# EUROPEAN PATENT APPLICATION

(11) **EP 4 552 844 A1**
(43) Date of publication of application: **14.05.2025**
(21) Application number: 23835554.9
(22) Date of filing: 05.07.2023
(51) Int. Cl.: B32B 27/10, B32B 27/20, B32B 29/00, B65D 65/40, D21H 19/36, D21H 19/82

(54) **BASE PAPER FOR METALLIZED PAPER, METALLIZED PAPER, PACKAGING BAG, LAMINATE, AND PAPER CONTAINER FOR LIQUID**

(30) Priority: 06.07.2022 JP 2022109283; 07.09.2022 JP 2022142414; 08.11.2022 JP 2022178850
(71) Applicant: Oji Holdings Corporation, Chuo-ku Tokyo 104-0061 (JP)
(72) Inventor: SHAMOTO, Yuta, Tokyo 104-0061 (JP); WAKABAYASHI, Misaki, Tokyo 104-0061 (JP); NAMIOKA, Moeka, Tokyo 104-0061 (JP); NOISHIKI, Yasutomo, Tokyo 104-0061 (JP)
(74) Representative: Jones, Nicholas Andrew
(86) International application number: PCT/JP2023/024872
(87) International publication number: WO 2024/010023

(57) **Abstract**

Provided is base paper for vapor deposition paper, the base paper including, on at least one surface of a paper substrate, a clay coat layer and a resin layer in the order mentioned from the paper substrate, wherein the clay coat layer includes an inorganic pigment and a binder, the mass ratio (inorganic pigment/binder) of the inorganic pigment to the binder in the clay coat layer is from 25/75 to 75/25, and the coating amount (in terms of solid content) of the clay coat layer is 8 g/m² or more and 20 g/m² or less.

## Description

### TECHNICAL FIELD

The present disclosure relates to base paper for vapor deposition paper, vapor deposition paper using the base paper for vapor deposition paper, a packaging bag using the vapor deposition paper, a laminate including the vapor deposition paper, and a paper container for liquid using the laminate.

### BACKGROUND ART

Vapor deposition paper with barrier properties, in which a vapor deposition layer is disposed on a paper substrate, is used as a packaging material for preventing degradation in the quality of a food, a medical supply, an electronic component, or the like. In use of such vapor deposition paper, the vapor deposition paper is commonly processed into a packaging container, a tray, a packaging bag, or the like depending on an object to be packaged.

Working such as, for example, bending work is required for allowing vapor deposition paper to have a desired shape. However, the working has sometimes caused damage, such as cracking, to a vapor deposition layer with barrier properties to degrade the barrier properties of the vapor deposition paper.

Thus, research on a technology for maintaining the barrier properties of vapor deposition paper even after bending work has been conducted.

For example, Patent Literature 1 (JP 2021-035753 A) discloses a paper laminate including a resin layer containing a water-suspensible polymer and a plate-shaped inorganic compound having an aspect ratio of 80 or more on at least one surface of a paper substrate, and a vapor deposition layer including a metal or ceramics having thickness of 1 to 1000 nm on the resin layer. In Patent Literature 1, the vapor deposition layer is formed on the resin layer, whereby the vapor deposition layer is protected, and, as a result, the barrier properties of the paper laminate can be maintained even after working.

### SUMMARY OF INVENTION

Use of the paper laminate described in Patent Literature 1 can suppress degradation in the barrier properties, resulting from working. However, in order to increase the number of options of means for maintaining barrier properties even after working, further development of the means is demanded.

An objective of the present disclosure is to provide base paper for vapor deposition paper, enabling production of vapor deposition paper which is excellent in barrier properties such as gas barrier properties (particularly, oxygen barrier property) and a water vapor barrier property, and of which the excellent barrier properties can be maintained even after bending work of the vapor deposition paper.

The present inventors found that vapor deposition paper excellent in barrier properties and working resistance can be provided by forming a clay coat layer including a blend of an inorganic pigment and a binder at a specific mass ratio, and setting the coating amount of the clay coat layer at a certain amount, in base paper for vapor deposition paper, including a paper substrate, the clay coat layer, and a resin layer in the order mentioned. In other words, the gist of the present disclosure is as follows.

In other words, the present disclosure relates to the following [1] to [9].
[1] Base paper for vapor deposition paper, the base paper comprising, on at least one surface of a paper substrate, a clay coat layer and a resin layer in order mentioned from the paper substrate, wherein
   the clay coat layer comprises an inorganic pigment and a binder,
   a mass ratio (inorganic pigment/binder) of the inorganic pigment to the binder in the clay coat layer is from 25/75 to 75/25, and
   a coating amount (in terms of solid content) of the clay coat layer is 8 g/m² or more and 20 g/m² or less.
[2] The base paper for vapor deposition paper according to [1], wherein the inorganic pigment comprises one or more selected from the group consisting of kaolin and calcium carbonate.
[3] The base paper for vapor deposition paper according to [1] or [2], wherein the binder comprises one or more selected from the group consisting of a styrene-(meth)acrylic resin, an ethylene-(meth)acrylic acid copolymer, a styrene-butadiene resin, and polylactic acid.
[4] The base paper for vapor deposition paper according to any one of [1] to [3], wherein the resin layer comprises one or more selected from the group consisting of a polyurethane resin and polylactic acid.
[5] Vapor deposition paper comprising the base paper for vapor deposition paper according to any one of [1] to [4] and a vapor deposition layer, wherein
   the vapor deposition layer is disposed on the resin layer of the base paper for vapor deposition paper.
[6] The vapor deposition paper according to [5], wherein at least one of an overcoat layer and a heat seal layer is disposed on the vapor deposition layer.
[7] A packaging bag using the vapor deposition paper according to [5] or [6].
[8] A laminate comprising a thermoplastic resin layer, the vapor deposition paper according to [5] or [6], and a sealant layer in this order.
[9] A paper container for liquid, comprising the laminate according to [8].

### DESCRIPTION OF EMBODIMENTS

Specific embodiments of the present disclosure are described in detail below. The configuration of each embodiment is not limited to the following contents without departing from the gist of the present disclosure, and can be changed as appropriate.

Herein, a description of "X or more and Y or less" or "X to Y" representing a numerical range means a numerical range including lower and upper limits which are end points, unless otherwise specified. When the lower and upper limit values of a numerical range are individually described, the numerical range may include a combination of an optional lower limit value and an optional upper limit value.

Herein, the phrase "Z is on layer" means that Z is positioned directly on the layer (that is, Z is at a position adjacent to the layer) or Z is arranged so that an optional layer is between Z and the layer.

### [Base Paper for Vapor deposition paper]

Base paper for vapor deposition paper according to one embodiment of the present disclosure includes, on at least one surface of a paper substrate, a clay coat layer and a resin layer in the order mentioned from the paper substrate, wherein the clay coat layer includes an inorganic pigment and a binder, the mass ratio (inorganic pigment/binder) of the inorganic pigment to the binder in the clay coat layer is from 25/75 to 75/25, and the coating amount (in terms of solid content) of the clay coat layer is 8 g/m² or more and 20 g/m² or less. The base paper for vapor deposition paper of the present embodiment can provide vapor deposition paper which is excellent in barrier properties, and of which the excellent barrier properties can be maintained even after bending work of the vapor deposition paper, and can also provide a packaging bag, a laminate, and a paper container for liquid using the vapor deposition paper.

"Base paper for vapor deposition paper" is paper for obtaining vapor deposition paper by forming a vapor deposition layer on at least one surface thereof. A method of forming the vapor deposition layer is not particularly limited, and may be direct vapor deposition of the vapor deposition layer on the base paper for vapor deposition paper, transfer of the vapor deposition layer, and the like.

Use of the base paper for vapor deposition paper of the present embodiment enables providing the vapor deposition paper exhibiting high barrier properties, particularly a high oxygen barrier property and a water vapor barrier property, regardless of the presence or absence of bending work. Herein, a characteristic in which barrier properties can be maintained even after bending work may be referred to as "working resistance".

The base paper for vapor deposition paper of the present embodiment may include, on one surface of the paper substrate, a clay coat layer and a resin layer in this order, or may include, on both surfaces of the paper substrate, clay coat layers and resin layers in this order. From the viewpoint of production efficiency, the base paper preferably includes, on one surface of the paper substrate, the clay coat layer and the resin layer in this order. The base paper for vapor deposition paper of the present embodiment may also include a layer other than the clay coat layer and the resin layer unless the effects of the present disclosure are not impaired.

### <Paper substrate>

Pulp included in the paper substrate in the present embodiment preferably includes, as a main component, a pulp derived from a plant and more preferably includes a wood pulp as a main component. Examples of the wood pulp include hardwood pulps and softwood pulps. Examples of non-wood pulps include cotton pulps, hemp pulps, kenaf pulps, and bamboo pulps. The paper substrate may contain a material other than pulp fibers, for example, a synthetic fiber such as a rayon fiber or a nylon fiber unless the effects of the present disclosure are not impaired.

The rate of a hardwood pulp with respect to the pulp included in the paper substrate is preferably 65% by mass or more, more preferably 80% by mass or more, still more preferably 90% by mass or more, and even more preferably 95% by mass or more, and may be 100% by mass, from the viewpoint of improvement in recyclability.

Specific examples of the paper substrate used in the base paper for vapor deposition paper of the present embodiment include bleached kraft paper, unbleached kraft paper, high-quality paper, paperboard, liner paper, coated paper, machine-glazed kraft paper, glassine paper, graphan paper, coated board, card paper, ivory paper, paperboard such as manila board, milk carton paper, and cup base paper. Of these, the paper substrate is preferably bleached kraft paper, unbleached kraft paper, high-quality paper, or machine-glazed kraft paper. In the case of an application to a paper container for liquid, the paper substrate is preferably a material that functions as a base layer retaining a laminate and can apply strength for a material for the paper container for liquid to the laminate.

### (Sizing Degree)

The sizing degree of the paper substrate is not particularly limited, and the Stockigt sizing degree thereof according to JIS P 8122: 2004 is preferably set at 1 second or more from the viewpoint of improving barrier properties. The upper limit of the sizing degree of the paper substrate is not particularly limited, and is preferably 100 seconds or less, and more preferably 30 seconds or less. The sizing degree of the paper substrate can be controlled by the kind of an internal sizing agent, the content of the internal sizing agent, the kind of the pulp, smoothing treatment, and the like.

Examples of the internal sizing agent include a rosin type, an alkyl ketene dimer type, an alkenyl succinic anhydride type, a styrene-unsaturated carboxylic acid type, a higher fatty acid type, a petroleum resin type, and the like. The content of the internal sizing agent is not particularly limited, and is preferably 3 parts by mass or less with respect to 100 parts by mass of the pulp in the paper substrate.

Besides the internal sizing agent, other known internal additives may be added to the paper substrate. Examples of the internal additives include fillers, paper strengthening agents, yield improving agents, pH adjusting agents, freeness improving agents, waterproofing agents, softening agents, antistatic agents, antifoaming agents, slime control agents, dyes, and pigments.

Examples of the fillers include titanium dioxide, kaolin, talc, calcium carbonate (heavy calcium carbonate, precipitated calcium carbonate), calcium sulfite, gypsum, calcined kaolin, white carbon, amorphous silica, delaminated kaolin, diatomaceous earth, magnesium carbonate, aluminum hydroxide, calcium hydroxide, magnesium hydroxide, and zinc hydroxide.

The paper substrate is obtained by making paper from a raw material for making paper, containing pulp slurry as a main component.

The pulp slurry is obtained from a wood or non-wood raw chip through steps of cooking, washing, bleaching, and the like. The cooking step, the washing step, the bleaching step, and the like can be performed according to a known method or a method similar to the method. The pulp slurry obtained through the steps is further beaten in the presence of water.

In making of paper from the paper substrate, a known wet-type papermaking machine can be selected and used as appropriate. Examples of the papermaking machine include fourdrinier papermaking machines, gap former type papermaking machines, cylinder papermaking machines, and short-fourdrinier papermaking machines. It is preferable that a paper layer formed by the papermaking machine is conveyed by, for example, felt, and dried by a dryer. A multistage cylinder dryer may be used as a pre-dryer before drying by the dryer.

The paper substrate obtained as described above may be subjected to surface treatment by calendering to result in uniformization of the profile of a paper thickness or glossiness. The calendering can be performed by a known calendaring machine.

### (Basis Weight)

The basis weight of the paper substrate is not particularly limited, and is preferably 20 g/m² or more, more preferably 30 g/m² or more, and still more preferably 40 g/m² or more, and preferably 500 g/m² or less, more preferably 400 g/m² or less, still more preferably 200 g/m² or less, even more preferably 150 g/m² or less, and particularly preferably 100 g/m² or less in the case of a flexible packaging application such as a packaging bag. In other words, examples of the preferred range of the basis weight of the paper substrate include ranges of 20 g/m² or more and 500 g/m² or less, 30 g/m² or more and 400 g/m² or less, 40 g/m² or more and 200 g/m² or less, 40 g/m² or more and 150 g/m² or less, and 40 g/m² or more and 100 g/m² or less in the case of a flexible packaging application such as a packaging bag. The basis weight of the paper substrate is preferably 100 g/m² or more, more preferably 200 g/m² or more, and still more preferably 300 g/m² or more, and preferably 1000 g/m² or less, more preferably 700 g/m² or less, and still more preferably 400 g/m² or less in the case of an application to a paper container for liquid. In other words, examples of the preferred range of the basis weight of the paper substrate include ranges of 100 g/m² or more and 1000 g/m² or less, 200 g/m² or more and 700 g/m² or less, and 300 g/m² or more and 400 g/m² or less in the case of an application to a paper container for liquid. When the basis weight of the paper substrate layer is 100 g/m² or more, sufficient strength can be applied to the laminate, and the paper substrate can be preferably used for an application to a paper container for liquid. When the basis weight of the paper substrate is 1000 g/m² or less, resistance in working into a paper container for liquid and a reduction in load in the case of transportation can be expected. The basis weight of the paper substrate is measured according to JIS P 8124: 2011.

### (Thickness)

The thickness of the paper substrate is not particularly limited, and is preferably 5 µm or more, more preferably 10 µm or more, and still more preferably 20 µm or more, and preferably 200 µm or less, preferably 150 µm or less, more preferably 100 µm or less, and still more preferably 75 µm or less in the case of a flexible packaging application such as a packaging bag. In other words, examples of the preferred range of the thickness of the paper substrate include ranges of 5 µm or more and 200 µm or less, 10 µm or more and 150 µm or less, 20 µm or more and 100 µm or less, and 20 µm or more and 75 µm or less in the case of a flexible packaging application such as a packaging bag. The thickness of the paper substrate is preferably 100 µm or more, more preferably 300 µm or more, and preferably 1000 µm or less, and more preferably 800 µm or less in the case of an application to a paper container for liquid. In other words, examples of the preferred range of the thickness of the paper substrate include ranges of 100 µm or more and 1000 µm or less, and 300 µm or more and 800 µm or less in the case of an application to a paper container for liquid. The thickness of the paper substrate is measured according to JIS P 8118: 2014.

### (Density)

The density of the paper substrate is preferably 0.5 g/cm³ or more, and more preferably 0.6 g/cm³ or more, and preferably 1.2 g/cm³ or less, and more preferably 1.0 g/cm³ or less from the viewpoint of shape formability. In other words, examples of the preferred range of the density of the paper substrate include ranges of 0.5 g/cm³ or more and 1.2 g/cm³ or less, and 0.6 g/cm³ or more and 1.0 g/cm³ or less. The density of the paper substrate is calculated from the basis weight and thickness of the paper substrate, measured by the methods described above.

### (Oken Smoothness)

The Oken smoothness of a surface on which the vapor deposition layer of the paper substrate is disposed is preferably 5 seconds or more, more preferably 10 seconds or more, still more preferably 100 seconds or more, and even more preferably 300 seconds or more, and preferably 1000 seconds or less from the viewpoint of obtaining a uniform vapor deposition layer. **In** other words, examples of the preferred range of the Oken smoothness of the surface on which the vapor deposition layer of the paper substrate is disposed include ranges of 5 seconds or more and 1000 seconds or less, 10 seconds or more and 1000 seconds or less, 100 seconds or more and 1000 seconds or less, and 300 seconds or more and 1000 seconds or less. The Oken smoothness of the paper substrate is measured according to JIS P 8155: 2010.

### <Clay coat layer>

The base paper for vapor deposition paper of the present embodiment includes a clay coat layer between the paper substrate and a resin layer described later. As a result, the paper substrate can be filled and smoothed, and a flatter resin layer can be formed. As a result, the uniform vapor deposition layer can be formed on the resin layer, and the barrier properties of the vapor deposition paper can be improved.

It is preferable that the clay coat layer primarily includes an inorganic pigment and a binder. The phrase "clay coat layer primarily includes inorganic pigment and binder" means that the total content of the inorganic pigment and the binder in the clay coat layer is, for example, 50% by mass or more, preferably 60% by mass or more, more preferably 70% by mass or more, still more preferably 80% by mass or more, particularly preferably 90% by mass or more, and most preferably 95% by mass or more. The upper limit of the total content of the inorganic pigment and the binder in the clay coat layer is not particularly limited, and may be 100% by mass. The clay coat layer may further include an optional component as well as the inorganic pigment and the binder.

### (Inorganic Pigment)

The inorganic pigment included in the clay coat layer is not particularly limited, and examples thereof include kaolin, talc, mica, and calcium carbonate. Such inorganic pigments may be used singly, or in combination of two or more kinds thereof. Especially, the inorganic pigment preferably includes one or more selected from the group consisting of kaolin and calcium carbonate, and more preferably includes kaolin.

The content of the inorganic pigment in the clay coat layer is preferably 25% by mass or more, more preferably 30% by mass or more, and still more preferably 40% by mass or more, and preferably 75% by mass or less, more preferably 70% by mass or less, and still more preferably 65% by mass or less from the viewpoint of improving the working resistance of the vapor deposition paper. In other words, examples of the preferred range of the content of the inorganic pigment in the clay coat layer include ranges of 25% by mass or more and 75% by mass or less, 30% by mass or more and 70% by mass or less, and 40% by mass or more and 65% by mass or less.

The mass ratio (inorganic pigment/binder) of the inorganic pigment to the binder in the clay coat layer is usually 25/75 or more, preferably 30/70 or more, and more preferably 40/60 or more, and usually 75/25 or less, preferably 70/30 or less, and more preferably 65/35 or less. In other words, examples of the preferred range of the mass ratio of the inorganic pigment to the binder in the clay coat layer include ranges from 25/75 to 70/30, from 30/70 to 75/25, and from 40/60 to 65/35. In vapor deposition paper produced using base paper for vapor deposition paper in which the mass ratio of an inorganic pigment to a binder is in the range described above, damage to a vapor deposition layer due to bending work is inhibited from occurring, and excellent barrier properties can be maintained even after the bending work.

The aspect ratio of the inorganic pigment is preferably 75 or less, and more preferably 50 or less, from the viewpoints of forming a uniform and smooth resin layer and of finely dispersing the inorganic pigment in the clay coat layer to improve the disintegration properties of the base paper for vapor deposition paper. The lower limit of the aspect ratio of the inorganic pigment is not particularly limited, and is preferably 1 or more. In other words, examples of the preferred range of the aspect ratio of the inorganic pigment include ranges of 1 or more and 75 or less, and 1 or more and 50 or less.

The aspect ratio of the inorganic pigment is calculated by the following method. First, a cross section of the base paper for vapor deposition paper in thickness direction is photographed to obtain an electron micrograph, and the lengths and thicknesses of at least 30 inorganic pigments are measured and arithmetically averaged to determine an average length and an average thickness. Then, a value obtained by dividing the average length of the inorganic pigments by the average thickness of the inorganic pigments is determined as the aspect ratio of the inorganic pigment.

### (Binder)

The binder included in the clay coat layer is not particularly limited, and examples thereof include styrene-(meth)acrylic resins; olefin-unsaturated carboxylic acid copolymers such as ethylene-(meth)acrylic acid copolymers; styrene-butadiene resins; (meth)acrylic (co)polymers; and polyester resins such as polylactic acid. These may be used singly, or in combination of two or more kinds thereof. Of these, one or more selected from styrene-(meth) acrylic resins, olefin-unsaturated carboxylic acid copolymers, styrene-butadiene resins, and polyester resins are preferably included, and one or more selected from styrene-(meth)acrylic resins, ethylene-(meth)acrylic acid copolymers, styrene-butadiene resins, and polylactic acid are more preferably included. More specifically, a styrene-(meth)acrylic resin and a styrene-butadiene resin are preferred in view of enabling a reduction in production cost because of being inexpensive, an ethylene-(meth)acrylic acid copolymer is preferred in view of enabling realization of high film formation properties, and polylactic acid is preferred in view of enabling a reduction in environmental load because of being a biodegradable resin.

Herein, the styrene-(meth) acrylic resin is a copolymer of styrene and at least one monomer selected from (meth)acrylic acid and (meth)acrylate esters. The styrene-(meth)acrylic resin preferably includes a styrene-acrylic resin, and more preferably includes one or more selected from styrene-acrylic acid copolymers and styrene-acrylate ester copolymers.

Herein, the (meth)acrylic (co)polymer is a (co)polymer of one or more monomers selected from (meth)acrylic acid and (meth)acrylate esters. The (meth)acrylate ester is preferably a C₁₋₁₂-alkyl ester of (meth)acrylic acid.

A commercially available product may be used as the styrene-(meth) acrylic resin, and examples thereof include "Acronal S504" and "Acronal S728" manufactured by BASF AG; and "SEIKOAT RE-2016" manufactured by SEIKO PMC Corporation.

A commercially available product may be used as the ethylene-(meth) acrylic acid copolymer, and examples thereof include "CHEMIPEARL S-100", "CHEMIPEARL S-300", and "CHEMIPEARL S-500" manufactured by Mitsui Chemicals, Inc.; and "ZAIKTHENE AC" manufactured by Sumitomo Seika Chemicals Company, Limited.

A commercially available product may be used as the styrene-butadiene resin, and examples thereof include "Styronal ES7900", "Styronal ES7902", and "Styronal ES316S" manufactured by BASF AG.

A commercially available product may be used as the polylactic acid, and examples thereof include "RESEM W-990" manufactured by CHUKYO YUSHI CO., LTD., and "LANDY PL-3000" manufactured by MIYOSHI OIL & FAT CO., LTD.

The upper limit of the glass transition temperature of the binder is not particularly limited, and is preferably 70°C or less, more preferably 60°C or less, still more preferably 30°C or less, and even more preferably 10°C or less from the viewpoint of securing the flexibility of the clay coat layer. The lower limit of the glass transition temperature of the binder is not particularly limited, and is preferably -30°C or more, more preferably -20°C or more, and still more preferably -10°C or more from the viewpoint of realizing favorable blocking resistance. In other words, examples of the preferred range of the glass transition temperature of the binder include ranges of -30°C or more and 70°C or less, -20°C or more and 60°C or less, -10°C or more and 30°C or less, and -10°C or more and 10°C or less. The glass transition temperature is measured according to JIS K7122: 2012.

The content of the binder in the clay coat layer is preferably 25% by mass or more, more preferably 30% by mass or more, and still more preferably 35% by mass or more, and preferably 75% by mass or less, more preferably 70% by mass or less, and still more preferably 60% by mass or less from the viewpoint of improving the working resistance of the vapor deposition paper. In other words, examples of the preferred range of the content of the binder in the clay coat layer include ranges of 25% by mass or more and 75% by mass or less, 30% by mass or more and 70% by mass or less, and 35% by mass or more and 60% by mass or less.

### (Coating Amount)

The coating amount of the clay coat layer is usually 8 g/m² or more, preferably 10 g/m² or more, and more preferably 12 g/m² or more, and usually 20 g/m² or less, preferably 18 g/m² or less, and more preferably 16 g/m² or less in terms of solid content. In other words, examples of the preferred range of the coating amount (in terms of solid content) of the clay coat layer include ranges of 8 g/m² or more and 18 g/m² or less, 10 g/m² or more and 20 g/m² or less, and 12 g/m² or more and 16 g/m² or less. In vapor deposition paper produced using base paper for vapor deposition paper in which the coating amount of a clay coat layer is in the range described above, damage to a vapor deposition layer due to bending work is inhibited from occurring, and excellent barrier properties can be maintained even after the bending work.

### <Resin Layer>

The base paper for vapor deposition paper of the present embodiment includes the resin layer placed on the clay coat layer. Disposition of the resin layer results in improvement in adhesiveness between the base paper for vapor deposition paper and the vapor deposition layer of vapor deposition paper, and in improvement in barrier properties. When the resin layer in itself has barrier properties, the barrier properties of the vapor deposition paper can be improved.

The resin layer preferably includes a water-suspensible polymer and, more preferably, principally includes a water-suspensible polymer. The phrase "resin layer principally includes water-suspensible polymer" means that the content of the water-suspensible polymer in the resin layer is, for example, 50% by mass or more, preferably 60% by mass or more, more preferably 70% by mass or more, still more preferably 80% by mass or more, particularly preferably 90% by mass or more, and most preferably 95% by mass or more. The upper limit of the content of the water-suspensible polymer in the resin layer is not particularly limited, and may be 100% by mass. The resin layer may further include an optional component as well as the water-suspensible polymer.

### (Water-Suspensible Polymer)

The water-suspensible polymer included in the resin layer is not particularly limited, and examples thereof include alkyd resins; olefin-unsaturated carboxylic acid copolymers such as (meth)acrylic (co)polymers, styrene-(meth)acrylic resins, ethylene-acrylic acid copolymers and ethylene-methacrylic acid copolymers; vinyl alcohol resins such as polyvinyl alcohol and ethylene-vinyl alcohol copolymers (ethylene-modified polyvinyl alcohols); cellulosic resins; polyurethane resins; and polyester resins such as polylactic acid. These may be used singly, or in combination of two or more kinds thereof. Of these, the water-suspensible polymer preferably includes one or more selected from vinyl alcohol resins, polyurethane resins, and polyester resins, more preferably includes one or more selected from polyester resins and polyurethane resins from the viewpoint of further improving the biodegradability and recyclability of the vapor deposition paper, and still more preferably includes a polyurethane resin.

### <<Polyester Resin>>

The polyester resin included in the resin layer is not particularly limited, and preferred examples thereof include polyester resins that can be dispersed (including emulsified) in an aqueous solvent. The polyester resin is preferably a biodegradable polyester resin that can be dispersed in an aqueous solvent, and more preferably polylactic acid.

A commercially available product may be used as the polyester resin, examples thereof include "Elitel KT Series (registered trademark)" manufactured by UNITIKA LTD., "LANDY PL Series (registered trademark)" manufactured by MIYOSHI OIL & FAT CO., LTD., and "RESEM W Series (registered trademark)" manufactured by CHUKYO YUSHI CO., LTD., and specific examples thereof include Elitel KT-8803, LANDY PL-3000, and RESEM W-990.

### <<Polyurethane Resin>>

The polyurethane resin included in the resin layer is not particularly limited, and preferred examples thereof include polyurethane resins that can be dispersed (including emulsified) in an aqueous solvent.

The polyurethane resin preferably contains one or more selected from the group consisting of structural units derived from m-xylylene diisocyanate and structural units derived from hydrogenated m-xylylene diisocyanate. When the polyurethane resin contains at least one of a structural unit derived from m-xylylene diisocyanate and a structural unit derived from hydrogenated m-xylylene diisocyanate, the total content of the structural unit derived from m-xylylene diisocyanate and the structural unit derived from hydrogenated m-xylylene diisocyanate with respect to the total amount of structural units derived from polyisocyanate is preferably 50% by mol or more. Such a polyurethane resin exhibits a high cohesive force due to a hydrogen bond and a stacking effect between xylylene groups, and therefore has excellent barrier properties. The above-described content can be identified using a known analysis method such as ¹H-NMR.

The polyurethane resin may have a hydroxy group, and preferably has a hydroxyl value of 50 mg KOH/g or more, more preferably 100 mg KOH/g or more, and still more preferably 150 mg KOH/g or more. The upper limit of the hydroxyl value of the polyurethane resin is not particularly limited, and is preferably 1000 mg KOH/g or less, more preferably 800 mg KOH/g or less, and still more preferably 600 mg KOH/g or less. In other words, examples of the preferred range of the hydroxyl value of the polyurethane resin include ranges of 50 mg KOH/g or more and 1000 mg KOH/g or less, 100 mg KOH/g or more and 800 mg KOH/g or less, and 150 mg KOH/g or more and 600 mg KOH/g or less. In a case in which the hydroxyl value of the polyurethane resin is in the range described above, the case is preferred because of an excellent oxygen barrier property.

### -Oxygen Permeability-

The oxygen permeability of the polyurethane resin at 23°C and 50% RH in the case of forming a sheet having thickness of 25 µm is preferably 100 mL/(m²·day·atm) or less, more preferably 50 mL/(m²·day·atm) or less, still more preferably 25 mL/(m²·day·atm) or less, and particularly preferably 10 mL/(m²·day·atm) or less. Herein, the oxygen permeability is measured under conditions of 23°C and 50% RH using an oxygen permeability measuring device (OX-TRAN2/22 manufactured by MOCON).

### -Glass Transition Temperature-

The glass transition temperature of the polyurethane resin is preferably 150°C or less, more preferably 140°C or less, and still more preferably 135°C or less from the viewpoint of protecting the vapor deposition layer of the vapor deposition paper and from the viewpoint of film formation properties. The lower limit of the glass transition temperature of the polyurethane resin is not particularly limited, and preferably 50°C or more. The glass transition temperature is measured according to JIS K 7122: 2012.

A synthetic product may be used as the polyurethane resin, and examples thereof include a polyurethane resin described in WO 2015/016069 A1.

A commercially available product may be used as the polyurethane resin, examples thereof include "TAKELAC W series (registered trademark)", "TAKELAC WPB series (registered trademark)", and "TAKELAC WS series (registered trademark)" manufactured by Mitsui Chemicals, Inc., and specific examples thereof include TAKELAC WPB-341. Additional examples of the commercially available product of the polyurethane resin include "HPU W-003" (hydroxyl value of 235 mg KOH/g) manufactured by Dainichiseika Color & Chemicals Mfg. Co., Ltd.

The resin layer may include an additional component as well as the water-suspensible polymer described above as long as the effects of the present disclosure are not impaired. Examples of the additional component include silane coupling agents, surfactants, dispersants, pigments, antioxidants, antistatic agents, dyes, plasticizers, lubricants, and mold release agents.

### (Coating Amount)

The coating amount of the resin layer is not particularly limited, and is preferably 0.1 g/m² or more, more preferably 0.5 g/m² or more, and still more preferably 1.0 g/m² or more, and preferably 10.0 g/m² or less, more preferably 5.0 g/m² or less, and still more preferably 3.0 g/m² or less in terms of solid content. In other words, examples of the preferred range of the coating amount (in terms of solid content) of the resin layer include ranges of 0.1 g/m² or more and 10.0 g/m² or less, 0.5 g/m² or more and 5.0 g/m² or less, and 1.0 g/m² or more and 3.0 g/m² or less.

### [Characteristics of Base Paper for Vapor deposition paper]

### (Basis Weight)

The basis weight of the base paper for vapor deposition paper of the present embodiment is not particularly limited. In the case of a flexible packaging application such as a packaging bag, the basis weight is preferably 20 g/m² or more, more preferably 30 g/m² or more, still more preferably 40 g/m² or more, and even more preferably 50 g/m² or more, and preferably 500 g/m² or less, more preferably 400 g/m² or less, still more preferably 200 g/m² or less, even more preferably 150 g/m² or less, and particularly preferably 100 g/m² or less. In other words, in the case of a flexible packaging application such as a packaging bag, examples of the preferred range of the basis weight of the base paper for vapor deposition paper include ranges of 20 g/m² or more and 500 g/m² or less, 30 g/m² or more and 400 g/m² or less, 40 g/m² or more and 200 g/m² or less, 50 g/m² or more and 150 g/m² or less, and 50 g/m² or more and 100 g/m² or less. In the case of an application to a paper container for liquid, the basis weight of the base paper for vapor deposition paper is preferably 100 g/m² or more, more preferably 200 g/m² or more, and still more preferably 300 g/m² or more, and preferably 1000 g/m² or less, more preferably 700 g/m² or less, and still more preferably 500 g/m² or less. In other words, in the case of an application to a paper container for liquid, examples of the preferred range of the basis weight of the base paper for vapor deposition paper include ranges of 100 g/m² or more and 1000 g/m² or less, 200 g/m² or more and 700 g/m² or less, and 300 g/m² or more and 500 g/m² or less. The basis weight of the base paper for vapor deposition paper is measured according to JIS P 8124: 2011.

### (Thickness)

The thickness of the base paper for vapor deposition paper of the present embodiment is not particularly limited. In the case of a flexible packaging application such as a packaging bag, the thickness is preferably 20 µm or more, more preferably 30 µm or more, still more preferably 40 µm or more, and even more preferably 50 µm or more, and preferably 250 µm or less, more preferably 200 µm or less, still more preferably 150 µm or less, even more preferably 100 µm or less, and particularly preferably 80 µm or less. In other words, in the case of a flexible packaging application such as a packaging bag, examples of the preferred range of the thickness of the base paper for vapor deposition paper include ranges of 20 µm or more and 250 µm or less, 30 µm or more and 200 µm or less, 40 µm or more and 150 µm or less, 50 µm or more and 100 µm or less, and 50 µm or more and 80 µm or less. In the case of an application to a paper container for liquid, the thickness of the base paper for vapor deposition paper is preferably 100 µm or more, more preferably 200 µm or more, and still more preferably 300 µm or more, and preferably 1000 µm or less, and more preferably 800 µm or less. In other words, in the case of an application to a paper container for liquid, examples of the preferred range of the thickness of the base paper for vapor deposition paper include ranges of 100 µm or more and 1000 µm or less, 200 µm or more and 800 µm or less, and 300 µm or more and 800 µm or less. The thickness of the base paper for vapor deposition paper is measured according to JIS P 8118: 2014.

### [Method of Producing Base Paper for Vapor deposition paper]

A method of producing the base paper for vapor deposition paper of the present embodiment is not limited, and preferably includes a step of forming a clay coat layer on at least one surface of a paper substrate; and a step of forming a resin layer on a clay coat layer.

The method of forming a clay coat layer is not particularly limited, and a method of coating a dispersion liquid including an inorganic pigment and a binder onto a paper substrate and drying the dispersion liquid to form a clay coat layer is preferably adopted as the method. As the dispersion liquid including the inorganic pigment and the binder, a dispersion liquid including, as a solvent, an aqueous medium such as an aqueous dispersion liquid is preferred.

A method of forming a resin layer is not particularly limited, and a method of coating and drying an aqueous coating liquid such as an aqueous solution including a water-suspensible polymer or an aqueous dispersion liquid to form a resin layer is preferably adopted as the method.

### [Vapor deposition paper]

The vapor deposition paper according to another embodiment of the present disclosure includes the above-described base paper for vapor deposition paper and the vapor deposition layer. The vapor deposition layer is disposed on the resin layer of the base paper for vapor deposition paper.

### <Vapor deposition layer>

The vapor deposition layer includes at least any of a layer including a metal, a layer including ceramics, and a layer including a carbonaceous material. In other words, the vapor deposition layer may include any of a layer including a metal, a layer including ceramics, a layer including a carbonaceous material, and a laminate thereof (for example, a laminate of a metal layer and a ceramic layer). When the vapor deposition layer is a laminate of two or more layers of a layer including a metal, a layer including ceramics, and a layer including a carbonaceous material, the order of layering each layer is not particularly limited. For example, when the vapor deposition layer is a laminate of a metal layer and a ceramic layer, the metal layer may be closer to the resin layer of the base paper for vapor deposition paper, or the ceramic layer may be closer to the resin layer of the base paper for vapor deposition paper.

The vapor deposition layer may include any of a layer including a metal, a layer including ceramics, a layer including a carbonaceous material, and a laminate thereof, and preferably includes a layer including a metal.

When the vapor deposition layer includes a layer including a metal, specific examples of the metal include aluminum and titanium, and preferably include aluminum. Such metals may be used singly, or in combination of two or more kinds thereof.

When the vapor deposition layer includes a layer including ceramics, specific examples of the ceramics include silicon oxide (silica), titanium oxide (titania), and aluminum oxide (alumina). Such ceramics may be used singly, or in combination of two or more kinds thereof. Of these, the ceramics preferably includes at least any of silicon oxide and aluminum oxide.

When the vapor deposition layer includes a layer including a carbonaceous material, specific examples of the carbonaceous material include diamond-like carbon, graphite, and graphene, and preferably include diamond-like carbon. The carbonaceous material may be used singly, or in combination of two or more kinds thereof.

In other words, the vapor deposition layer is more preferably any of a layer including aluminum, a layer including silicon oxide, a layer including titanium oxide, a layer including aluminum oxide, a layer including diamond-like carbon, and a laminate thereof, still more preferably any of a layer including aluminum, a layer including silicon oxide, a layer including aluminum oxide, a layer including diamond-like carbon, and a laminate thereof, and particularly preferably includes a layer including aluminum from the viewpoint of a cost and convenience resulting from widespread use of working apparatuses. Alternatively, the vapor deposition layer is preferably any of a layer including silicon oxide, a layer including aluminum oxide, a layer including diamond-like carbon, and a laminate thereof from the viewpoint of detactability by a metal detector and recyclability.

The thickness of the vapor deposition layer is not particularly limited, and is preferably 1 nm or more, more preferably 2 nm or more, and still more preferably 3 nm or more, and preferably 1000 nm or less, more preferably 500 nm or less, and still more preferably 100 nm or less. In other words, examples of the preferred range of the thickness of the vapor deposition layer include ranges of 1 nm or more and 1000 nm or less, 2 nm or more and 500 nm or less, and 3 nm or more and 100 nm or less.

The thickness of the vapor deposition layer is preferably 10 nm or more, more preferably 15 nm or more, still more preferably 20 nm, and even more preferably 25 nm or more, and preferably 80 nm or less, and more preferably 70 nm or less from the viewpoint of barrier properties. In other words, examples of the preferred range of the thickness of the vapor deposition layer include ranges of 10 nm or more and 80 nm or less, 15 nm or more and 80 nm or less, 20 nm or more and 70 nm or less, and 25 nm or more and 70 nm or less from the viewpoint of barrier properties.

Further, the thickness of the vapor deposition layer is preferably 4 nm or more, and more preferably 5 nm or more, and preferably 100 nm or less, more preferably 70 nm or less, and still more preferably 60 nm or less from the viewpoint of adhesiveness with another layer and a cost. In other words, examples of the preferred range of the thickness of the vapor deposition layer include ranges of 4 nm or more and 100 nm or less, 5 nm or more and 70 nm or less, and 5 nm or more and 60 nm or less from the viewpoint of adhesiveness with another layer and a cost.

### <Overcoat Layer>

The vapor deposition paper of the present embodiment may include an overcoat layer on the vapor deposition layer. The vapor deposition paper of the present embodiment includes the vapor deposition layer, whereby certain barrier properties are exhibited. The vapor deposition paper includes the overcoat layer on the vapor deposition layer, whereby the barrier properties of the vapor deposition paper can be further improved. Moreover, damage to the vapor deposition layer, caused by bending work, is suppressed, and the barrier properties are secured in the case of damaging the vapor deposition layer, whereby degradation in the barrier properties of the vapor deposition paper can be suppressed even after bending work.

In the vapor deposition paper of the present embodiment, the overcoat layer may be an outermost layer. Even if the overcoat layer is an outermost layer, the design quality of the vapor deposition layer having glossiness is not inhibited. When the vapor deposition paper includes vapor deposition layers on both surfaces of the base paper for vapor deposition paper, the vapor deposition paper may include overcoat layers on both the vapor deposition layers, or may include an overcoat layer only on one vapor deposition layer. Of these, the vapor deposition paper preferably includes the overcoat layer only on one vapor deposition layer from the viewpoint of improvement in the efficiency of production of the vapor deposition paper.

Examples of the binder included in the overcoat layer include alkyd resins; olefin-unsaturated carboxylic acid copolymers such as (meth)acrylic (co)polymers, styrene-(meth)acrylic resins, ethylene-acrylic acid copolymers and ethylene-methacrylic acid copolymers; vinyl alcohol resins such as polyvinyl alcohol and ethylene-vinyl alcohol copolymers (ethylene-modified polyvinyl alcohols); cellulosic resins; polyurethane resins; and polyester resins such as polylactic acid. These may be used singly, or in combination of two or more kinds thereof. Of these, the binder preferably includes one or more selected from vinyl alcohol resins, polyurethane resins, and polyester resins, more preferably includes one or more selected from ethylene-vinyl alcohol copolymers, polyurethane resins, and polyester resins, and still more preferably includes a polyurethane resin from the viewpoint of further improving the recyclability of the vapor deposition paper. Moreover, the binder is preferably a resin that can be dispersed (including emulsification) in an aqueous solvent.

Examples of polyurethane resins and polyester resins which are binders include polyurethane resins and polyester resins included in the resin layer of the base paper for vapor deposition paper, respectively. The same applies to preferred aspects thereof. The kinds of the polyurethane resin in the resin layer and the polyurethane resin in the overcoat layer may be the same or different, and are preferably the same. Moreover, the kinds of the polyester resin in the resin layer and the polyester resin in an overcoat layer may be the same or different, and are preferably the same.

A commercially available product may be used as such an ethylene-vinyl alcohol copolymer, and examples thereof include "Soarnol 16DX" manufactured by Mitsubishi Chemical Corporation and "Eversorb #10" manufactured by NIHON CIMA CO., LTD.

The oxygen permeability of the binder included in the overcoat layer at 23°C and 50% RH in the case of forming a sheet having thickness of 25 µm is preferably 100 mL/(m²·day·atm) or less, more preferably 50 mL/(m²·day·atm) or less, still more preferably 25 mL/(m²·day·atm) or less, and particularly preferably 10 mL/(m²·day·atm) or less.

The content of the binder in the overcoat layer is preferably 80% by mass or more, more preferably 90% by mass or more, still more preferably 95% by mass or more, and particularly preferably 99% by mass or more. The upper limit of the content of the binder in the overcoat layer is not particularly limited, and may be 100% by mass.

The overcoat layer may include a resin and an additive other than the binder described above as long as the effects of the present disclosure are not impaired. Examples of the additives include surfactants, dispersants, pigments, antioxidants, antistatic agents, dyes, plasticizers, lubricants, and mold release agents. When the overcoat layer is formed by coating a coating liquid, the binder is preferably dispersed in an aqueous medium using a dispersant to prepare the coating liquid from the viewpoint of obtaining the film of a uniform overcoat layer.

The coating amount of the overcoat layer is preferably 0.1 g/m² or more, more preferably 0.2 g/m² or more, and still more preferably 0.3 g/m² or more, and preferably 10.0 g/m² or less, more preferably 7.0 g/m² or less, and still more preferably 4.0 g/m² or less in terms of solid content. In other words, examples of the preferred range of the coating amount (in terms of solid content) of the overcoat layer include ranges of 0.1 g/m² or more and 10.0 g/m² or less, 0.2 g/m² or more and 7.0 g/m² or less, and 0.3 g/m² or more and 4.0 g/m² or less.

The thickness of the overcoat layer is preferably 0.1 µm or more, more preferably 0.2 µm or more, and still more preferably 0.3 µm or more, and preferably 10.0 µm or less, more preferably 7.0 µm or less, and still more preferably 4.0 µm or less. In other words, examples of the preferred range of the thickness of the overcoat layer include ranges of 0.1 µm or more and 10.0 µm or less, 0.2 µm or more and 7.0 µm or less, and 0.3 µm or more and 4.0 µm or less. When the thickness of the overcoat layer is in the range described above, it is possible to improve the disintegration properties of paper in recycling and to improve recyclability while improving protective properties for the vapor deposition layer.

### <Heat Seal Layer>

The vapor deposition paper of the present embodiment preferably includes a heat seal layer on the vapor deposition layer. The heat seal layer is a layer capable of hot-melt adhesion and enables adhesion of vapor deposition paper to each other. The heat seal layer may be placed on the vapor deposition layer via the overcoat layer, or may be placed directly on the vapor deposition layer. The heat seal layer may be disposed by coating, or may be disposed by lamination, as described later.

Each of thermoplastic resins described as examples in the section of <Thermoplastic Resin Layer> described later can be used as the resin included in the heat seal layer, and examples thereof include synthetic resins such as polyethylene, polypropylene, ethylene-vinyl acetate polymers, polyvinyl acetate polymers, ethylene-(meth)acrylic acid copolymers, and styrene-(meth)acrylic acid copolymers; and biodegradable resins such as polylactic acid (PLA), polybutyrene succinate (PBS), polybutyrene succinate adipate (PBSA), and 3-hydroxybutanoic acid-3-hydroxyhexanoic acid copolymer (PHBH). These may be used singly, or in combination of two or more kinds thereof. Of these, the resin included in the heat seal layer preferably includes one or more selected from ethylene-(meth)acrylic acid copolymers, styrene-(meth)acrylic acid copolymers, and biodegradable resins, and more preferably includes one or more selected from ethylene-(meth)acrylic acid copolymers, styrene-acrylic acid copolymers, and polylactic acid. Some or all of structural units derived from (meth)acrylic acid may be converted into salts such as sodium salts and ammonia salts. In other words, the resin included in the heat seal layer may be an ionomer.

Commercially available products may be used as ethylene-(meth)acrylic acid copolymers and polylactic acid, and examples thereof include the above-described products, respectively.

Commercially available products may be used as styrene- (meth)acrylic acid copolymers, and examples thereof include "XP-8829" and "SEIKOATRE-2016" manufactured by SEIKO PMC Corporation.

The thickness of the heat seal layer is preferably 1 to 50 µm, and more preferably 3 to 30 µm. Moreover, the basis weight (coating amount in terms of solid content, if the heat seal layer is formed by coating) of the heat seal layer is preferably 1 to 50 g/m², and more preferably 3 to 30 g/m².

In the case of disposing the heat seal layer by coating, the thickness of the heat seal layer is preferably 1 to 20 µm, and the basis weight (coating amount) of the heat seal layer is preferably 1 to 20 g/m².

In the case of disposing the heat seal layer by lamination, the thickness of the heat seal layer is preferably 4 to 40 µm, and the basis weight of the heat seal layer is preferably 4 to 40 g/m².

### [Physical Properties of Vapor deposition paper]

### (Basis Weight)

The basis weight of the vapor deposition paper of the present embodiment is not particularly limited. In the case of a flexible packaging application such as a packaging bag, the basis weight is preferably 20 g/m² or more, more preferably 30 g/m² or more, still more preferably 40 g/m² or more, and even more preferably 50 g/m² or more, and preferably 500 g/m² or less, more preferably 400 g/m² or less, still more preferably 200 g/m² or less, even more preferably 150 g/m² or less, and particularly preferably 100 g/m² or less. In other words, in the case of a flexible packaging application such as a packaging bag, examples of the preferred range of the basis weight of the vapor deposition paper include ranges of 20 g/m² or more and 500 g/m² or less, 30 g/m² or more and 400 g/m² or less, 40 g/m² or more and 200 g/m² or less, 50 g/m² or more and 150 g/m² or less, and 50 g/m² or more and 100 g/m² or less. In the case of an application to a paper container for liquid, the basis weight of the vapor deposition paper is preferably 100 g/m² or more, more preferably 200 g/m² or more, and still more preferably 300 g/m² or more, and preferably 1000 g/m² or less, more preferably 700 g/m² or less, and still more preferably 500 g/m² or less. In other words, in the case of an application to a paper container for liquid, examples of the preferred range of the basis weight of the vapor deposition paper include ranges of 100 g/m² or more and 1000 g/m² or less, 200 g/m² or more and 700 g/m² or less, and 300 g/m² or more and 500 g/m² or less. The basis weight of the vapor deposition paper is measured according to JIS P 8124: 2011.

### (Thickness)

The thickness of the vapor deposition paper of the present embodiment is not particularly limited. In the case of a flexible packaging application such as a packaging bag, the thickness is preferably 20 µm or more, more preferably 30 µm or more, still more preferably 40 µm or more, and even more preferably 50 µm or more, and preferably 250 µm or less, more preferably 200 µm or less, still more preferably 150 µm or less, still more preferably 100 µm or less, and even more preferably 80 µm or less. In other words, in the case of a flexible packaging application such as a packaging bag, examples of the preferred range of the thickness of the vapor deposition paper include ranges of 20 µm or more and 250 µm or less, 30 µm or more and 200 µm or less, 40 µm or more and 150 µm or less, 50 µm or more and 100 µm or less, and 50 µm or more and 80 µm or less. In the case of an application to a paper container for liquid, the thickness of the vapor deposition paper is preferably 100 µm or more, more preferably 200 µm or more, and still more preferably 300 µm or more, and preferably 1000 µm or less, more preferably 800 µm or less, and still more preferably 600 µm or less. In other words, in the case of an application to a paper container for liquid, examples of the preferred range of the thickness of the vapor deposition paper include ranges of 100 µm or more and 1000 µm or less, 200 µm or more and 800 µm or less, and 300 µm or more and 600 µm or less. The thickness of the vapor deposition paper is measured according to JIS P 8118: 2014.

### [Oxygen Permeability]

Regarding the vapor deposition paper of the present embodiment, the oxygen permeability of a laminated sheet at a temperature of 23°C and a relative humidity of 50%, measured according to JIS K 7126-2: 2006, is 2.0 mL/m²·day·atm or less, preferably 1.0 mL/m²·day·atm or less, and more preferably 0.5 mL/m²·day·atm or less, where the laminated sheet is prepared by laminating a cast polypropylene film (CPP film) having thickness of 20 µm onto the over coat layer (onto the heat seal layer, if the vapor deposition paper has the heat layer on the vapor deposition layer without the over coat layer therebetween or has the heat seal layer on the overcoat layer) of the vapor deposition paper. The lower limit thereof is not particularly limited, and is preferably 0 mL/m²·day·atm or more, and 0.05 mL/m²·day·atm or more. In other words, examples of the preferred range of the oxygen permeability of the laminated sheet at a temperature of 23°C and a relative humidity of 50% include ranges of 0 mL/m²·day·atm or more and 2.0 mL/m²·day·atm or less, 0 mL/m²·day·atm or more and 1.0 mL/m²·day·atm or less, and 0.05 mL/m²·day·atm or more and 0.5 mL/m²·day·atm or less. For example, an adhesive agent is used for adhesion of the vapor deposition paper and the CPP film to each other. The kind and coating amount of the adhesive agent are not particularly limited, and are as described in, for example, Examples as long as the adhesive agent does not have an oxygen barrier property. The oxygen permeability can be decreased by, for example, allowing the resin layer to have the optimal thickness described above, improving the smoothness of the resin layer, and increasing the thickness of the vapor deposition layer. Here, the phrase "adhesive agent does not have oxygen barrier property" means that the adhesive agent can provide a laminated sheet having an oxygen permeability of 2000 mL/m²·day·atm or more at a temperature of 23°C and a relative humidity of 50% (may also be referred to as "50% RH"), measured according to JIS K 7126-2: 2006, by applying thereto a paper substrate having the Oken air resistance measured according to JIS P 8117: 2009 of 100 seconds or less at coating amount of 4 g/m² and then bonding the paper substrate and a CPP film having thickness of 20 µm.

### [Water Vapor Permeability]

The water vapor permeability of the vapor deposition paper of the present embodiment is preferably 1.5 g/(m²·day) or less, more preferably 1.0 g/(m²·day) or less, and still more preferably 0.8 g/(m²·day) or less at 40°C and 90% RH. The lower limit thereof is not particularly limited, and is preferably 0 g/ (m²·day) or more, 0.1 g/(m²·day) or more, and 0.2 g/(m²·day) or more. In other words, examples of the preferred range of the water vapor permeability of the vapor deposition paper at 40°C and 90% RH include ranges of 0 g/(m²·day) or more and 1.5 g/(m²·day) or less, 0.1 g/(m²·day) or more and 1.0 g/(m²·day) or less, and 0.2 g/(m²·day) or more and 0.8 g/(m²·day) or less. The water vapor permeability of the vapor deposition paper is measured according to JIS Z 0208: 1976 (Dish Method) Method B. The water vapor permeability can be decreased by, for example, allowing the resin layer to have the optimal thickness described above, improving the smoothness of the resin layer, and increasing the thickness of the vapor deposition layer.

### [Method of Producing Vapor deposition paper]

A method of producing the vapor deposition paper of the present embodiment is not limited, and preferably includes a step of forming a vapor deposition layer on a surface on which the resin layer of the above-described base paper for vapor deposition paper is disposed, and optionally includes a step of forming an overcoat layer on the vapor deposition layer, and a step of forming a heat seal layer on the vapor deposition layer or the overcoat layer.

A method of forming the vapor deposition layer is not particularly limited, and examples thereof include a method of vapor deposition of a metal or ceramics directly on a surface of the resin layer of the base paper for vapor deposition paper; and a method of transferring a metal layer or a ceramic layer formed on a substrate for transfer by vapor deposition or the like to the resin layer of the base paper for vapor deposition paper. Any of a batch-type vacuum deposition apparatus and a continuous-type vacuum deposition apparatus may be used in the case of forming the vapor deposition layer by vacuum evaporation. When the continuous-type vacuum deposition apparatus is used, operation steps of release to atmospheric pressure and depressurization in winding replacement can be omitted. Since the size of a wound base material that can be placed in the apparatus is limited, in particular, the winding length of a thick paper substrate is decreased in correspondence to the thickness thereof, and the number of times of atmospheric pressure release and depressurization is increased to produce vapor deposition paper having the same area. However, in the case of the continuous-type vacuum deposition apparatus, this step can be omitted, and therefore, the efficiency of producing vapor deposition paper is greatly improved.

It is preferable to directly form the overcoat layer (or the heat seal layer, when the overcoat layer is not disposed) on the vapor deposition layer from the viewpoint of efficiently protecting the vapor deposition layer and enhancing barrier properties. For a method of forming the overcoat layer and the heat seal layer, a coating liquid for an overcoat layer or a coating liquid for a heat seal layer is preferably coated and dried to obtain the overcoat layer and the heat seal layer. As a result, the overcoat layer or the heat seal layer that is a comparatively thin film of 10 µm or less can be formed. By forming such a comparatively thin overcoat layer or heat seal layer, excellent disintegration properties is imparted to the vapor deposition paper, and the recyclability of the vapor deposition paper can be improved.

Examples of the coating liquid for an overcoat layer and the coating liquid for a heat seal layer, used in such a case, include a solution containing a resin included in each layer and an organic solvent in which the resin can be dissolved; a dispersion liquid containing a resin included in each layer and an organic solvent in which the resin can be dispersed; and an aqueous dispersion liquid containing an aqueous medium and a resin included in each layer. The coating liquids are preferably aqueous dispersion liquids in view of coating properties and environmental load.

Examples of a method of coating the coating liquid for an overcoat layer and the coating liquid for a heat seal layer include a bar coating method, a blade coating method, a squeeze coating method, an air knife coating method, a roll coating method, a gravure coating method, and a transfer coating method, and a coater such as a fountain coater or a slit die coater may be used.

The vapor deposition paper including the overcoat layer and/or the heat seal layer can be obtained by drying the vapor deposition paper coated with the coating liquid for an overcoat layer and/or the coating liquid for a heat seal layer to remove the organic solvent or the aqueous medium.

The heat seal layer may be formed by laminating each of the resins described as examples in the section of <Heat Seal Layer> described above on the vapor deposition layer or the overcoat layer. A known method such as a melt extrusion lamination method or a dry lamination method can be used as a lamination method. **In** the dry lamination method, a known adhesive agent can be used. **In** other words, the vapor deposition paper of the present embodiment may include an adhesive layer between the vapor deposition layer or the overcoat layer and the heat seal layer.

### [Applications of Vapor deposition paper]

The vapor deposition paper of the present embodiment can be preferably used as a packaging material for food such as coffee, confectionery, or milk; a pharmaceutical product; a medical product; an electronic component; or the like by utilizing its excellent barrier properties. The barrier properties of the vapor deposition paper of the present embodiment can be maintained even after bending work. Of these, therefore, the vapor deposition paper can be preferably used in soft packaging materials such as packaging paper, packaging bags, lids, and labels; liquid containers (hereinafter also referred to as paper containers for liquid) such as milk cartons; packaging containers such as cups, trays, dishes, lid materials, and laminate tubes; and the like. A content to be packaged may be a liquid, a solid (particle, powdery matter, or the like), or a gel body.

### [Packaging Bag]

A packaging bag according to another embodiment of the present disclosure is a packaging bag using the vapor deposition paper described above. Examples of the shape of the packaging bag include standing pouch shapes, side seal shapes, two-way seal shapes, three-way seal shapes, four-way seal shapes, envelope paste seal shapes, butt seaming seal shapes (pillow seal shapes), the shapes of seals with folds, flat bottom seal shapes, rectangular bottom seal shapes, and gadget shapes.

The packaging bag of the present embodiment may be a packaging bag obtained by bending the portion having the heat seal layer in the vapor deposition paper described above or overlapping such two portions to allow the heat seal layers to face each other, and heat-sealing the peripheral edges thereof to form the shape described above, or may be a packaging bag obtained by bending the vapor deposition paper described above or overlapping two pieces of such vapor deposition paper, and adhesively bonding the peripheral edges thereof with an adhesive agent to form the shape described above. Alternatively, the packaging bag may be obtained by bending a laminate described later or overlapping such two laminates to allow sealant layers to face each other, and heat-sealing the peripheral edges thereof to form the shape described above.

### [Laminate]

A laminate according to another embodiment of the present disclosure includes a thermoplastic resin layer, the vapor deposition paper described above, and a sealant in this order. The laminate of the present embodiment is preferably used in a paper container for liquid because the vapor deposition paper has barrier properties, whereby oxygen and water vapor that permeate the laminate can be greatly reduced.

In the present embodiment, the vapor deposition paper described above preferably includes an overcoat layer on a vapor deposition layer from the viewpoint of securing barrier properties, and barrier properties after bending work. Moreover, the overcoat layer is more preferably the outermost layer of the vapor deposition paper. The laminate of the present embodiment may include an optional layer other than the layer described above unless effects exhibited by the vapor deposition paper described above are inhibited.

### (Basis Weight)

The basis weight of the laminate is preferably 100 g/m² or more, more preferably 200 g/m² or more, and still more preferably 300 g/m² or more from the viewpoint of holding the shape of a paper container for liquid, and is preferably 1000 g/m² or less, more preferably 700 g/m² or less, and still more preferably 500 g/m² or less from the viewpoint of workability and transportability. In other words, examples of the preferred range of the basis weight of the laminate include ranges of 100 g/m² or more and 1000 g/m² or less, 200 g/m² or more and 700 g/m² or less, and 300 g/m² or more and 500 g/m² or less.

The basis weight of the laminate is measured according to JIS P 8124: 2011. For the basis weight of the paper substrate layer included in the laminate, the material, thickness, density, and the like of the resin layer are specified by a known method and the following procedure, and the basis weight of the paper substrate can be then calculated. Specifically, the weight (overall weight) of the laminate cut into a predetermined size is measured, the laminate is then impregnated with an aqueous copper ethylene diamine solution or an aqueous solution of enzyme such as cellulase, complete dissolution of the paper substrate is confirmed, the weight of a portion excluding the paper substrate is measured, the weight of the portion excluding the paper substrate is subtracted from the overall weight to calculate the weight of only the paper substrate, and the basis weight of the paper substrate is measured.

### (Thickness)

The thickness of the laminate is preferably 100 µm or more, more preferably 200 µm or more, and still more preferably 300 µm or more from the viewpoint of holding the shape of the paper container for liquid, and is preferably 1000 µm or less, more preferably 800 µm or less, and still more preferably 600 µm or less from the viewpoint of workability and transportability. In other words, examples of the preferred range of the thickness of the laminate include ranges of 100 µm or more and 1000 µm or less, 200 µm or more and 800 µm or less, and 300 µm or more and 600 µm or less. The thickness of the laminate is measured according to JIS P 8118: 2014.

### <Thermoplastic Resin Layer>

The thermoplastic resin layer is a layer that is an outer surface (printing surface) of a paper container for liquid when, for example, the paper container for liquid described later is formed. When the paper container for liquid is formed, the thermoplastic resin layer and the sealant layer are heat-sealed.

The thermoplastic resin that is used in the thermoplastic resin layer is not particularly limited as long as the thermoplastic resin can be heat-sealed with the sealant layer. The thermoplastic resin in itself preferably has heat-sealing properties. Specific examples thereof include polyolefin resins such as low-density polyethylene (LDPE), linear low-density polyethylene (LLDPE), medium-density polyethylene (MDPE), high-density polyethylene (HDPE), ethylenepropylene copolymers, ethylene-butene copolymers, propylene-butene copolymers, propylene homopolymers, propylene-ethylene random copolymers, propylene-ethylene block copolymers, propylene-ethylene-butene copolymers, ethylene-vinyl acetate copolymers, polymethylpentene, polystyrene, polyvinyl chloride, and acrylonitrile-butadiene-styrene (ABS) resins; acryl resins such as ethylene-acrylic acid copolymers, ethylene-methacrylic acid copolymers, ethylene-methyl acrylate copolymers, ethylene-ethyl acrylate copolymers, and ethylene-methyl methacrylate copolymers; polyester resins such as cyclohexanedimethanol-modified polyethylene terephthalate copolymers, polyethylene terephthalate (PET), and polybutylene terephthalate (PBT); modified polyphenylene ether (PPE); polyamide resins; and biodegradable resins such as polylactic acid (PLA), polyhydroxy butyric acid (PHB), polybutyrene succinate (PBS), poly(butylene adipate-co-butylene terephthalate) (PBAT), polycaprolactone (PCL), and poly (3-hydroxy butyrate-co-3-hydroxy hexanoate)

(PHBH). Such thermoplastic resins may be used singly, or in combination of two or more kinds thereof.

A method of forming the thermoplastic resin layer is not particularly limited, and a known method or a method similar to the method can be adopted as appropriate. Examples of the known method or the method similar to the method include a method of melting a thermoplastic resin and extrusion-laminating the thermoplastic resin on vapor deposition paper; and a method of coating vapor deposition paper with emulsion including a thermoplastic resin. The thermoplastic resin that forms the thermoplastic resin layer preferably includes at least one selected from the group consisting of polyethylene and biodegradable resins, more preferably at least one selected from the group consisting of low-density polyethylene (LDPE), linear low-density polyethylene (LLDPE), and biodegradable resins, still more preferably at least one selected from the group consisting of low-density polyethylene (LDPE) and linear low-density polyethylene (LLDPE), and even more preferably low-density polyethylene (LDPE). Polyethylene is inexpensive and has appropriate flexibility, and is therefore preferably used as a material for a paper container for liquid.

The thickness of the thermoplastic resin layer is not particularly limited, and is preferably 5 µm or more, and more preferably 10 µm or more from the viewpoint of adhesiveness with the sealant layer, and preferably 40 µm or less, and more preferably 30 µm or less from the viewpoint of reduction in environmental load. In other words, examples of the preferred range of the thickness of the thermoplastic resin layer include ranges of 5 µm or more and 40 µm or less, and 10 µm or more and 30 µm or less.

The basis weight of the thermoplastic resin layer is not particularly limited, and is preferably 5 g/m² or more, and more preferably 10 g/m² or more from the viewpoint of adhesiveness with the sealant layer, and is preferably 40 g/m² or less, and more preferably 30 g/m² or less from the viewpoint of reduction in environmental load. In other words, examples of the preferred range of the basis weight of the thermoplastic resin layer include ranges of 5 g/m² or more and 40 g/m² or less, and 10 g/m² or more and 30 g/m² or less.

### <Sealant Layer>

The sealant layer is a layer that is an inner surface (liquid contact surface) of the paper container for liquid when, for example, a paper container for liquid is formed, and the thermoplastic resin layer and the sealant layer are heat-sealed when the paper container for liquid is formed.

The resin that is used in the sealant layer is not particularly limited as long as the resin has heat-sealing properties. Specifically, the thermoplastic resin described in the section of <Thermoplastic Resin Layer> described above can be used.

A method of forming the sealant layer is not particularly limited, and a known method or a method similar to the method can be adopted as appropriate. Examples of the known method or the method similar to the method include a method of melting a resin and extrusion-laminating the resin on vapor deposition paper; and a method of coating vapor deposition paper with emulsion including a resin. In such a case, an anchor layer may be disposed on the vapor deposition paper to further increase adhesiveness between the vapor deposition paper and the sealant layer. The resin that is used in the sealant layer preferably includes at least one selected from the group consisting of polyethylene, polyester resins, and biodegradable resins, more preferably includes at least one selected from the group consisting of low-density polyethylene (LDPE), linear low-density polyethylene (LLDPE), polyester resins, and biodegradable resins, and still more preferably includes at least one selected from the group consisting of low-density polyethylene (LDPE), linear low-density polyethylene (LLDPE), and polyester resins.

The thickness of the sealant layer is not particularly limited, and is preferably 10 µm or more, and more preferably 15 µm or more from the viewpoint of heat-sealing properties, and preferably 50 µm or less, and more preferably 30 µm or less from the viewpoint of reduction in environmental load. In other words, examples of the preferred range of the thickness of the sealant layer include ranges of 10 µm or more and 50 µm or less, and 15 µm or more and 30 µm or less.

The basis weight of the sealant layer is not particularly limited, and is preferably 10 g/m² or more, and more preferably 15 g/m² or more from the viewpoint of heat-sealing properties, and preferably 50 g/m² or less, and more preferably 30 g/m² or less from the viewpoint of reduction in environmental load. In other words, examples of the preferred range of the basis weight of the sealant layer include ranges of 10 g/m² or more and 50 g/m² or less, and 15 g/m² or more and 30 g/m² or less.

The sealant layer may have a single-layer structure, or may have a multi-layer structure including two or more layers. When the sealant layer has the multi-layer structure, resins used in the respective layers may be the same or different. The resin used in the sealant layer that is the outermost layer of the laminate is preferably low-density polyethylene (LDPE). Disposition of the sealant layer including low-density polyethylene (LDPE) as the outermost layer of the laminate inhibits excessive adhesive strength after sealing, and enables a paper container for liquid to have appropriate opening properties.

The layer configuration of the laminate according to the present embodiment is not particularly limited, and the laminate has, for example, the following configuration. The following configuration may further include another layer such as a print layer.
·Configuration in which LDPE layer, paper substrate, clay coat layer, resin layer, vapor deposition layer, overcoat layer, and LDPE layer are laminated in order mentioned from printing surface
·Configuration in which LDPE layer, paper substrate, clay coat layer, resin layer, vapor deposition layer, overcoat layer, and LLDPE layer are laminated in order mentioned from printing surface

### [Paper Container for Liquid]

Still another embodiment of the present disclosure is a paper container for liquid, including the laminate described above. The laminate described above is excellent in barrier properties, and can be therefore preferably used in a packaging container for a general liquid. The paper container for liquid according to the present embodiment is produced by forming the paper container by a known method or a method similar to the method. The shape of the paper container for liquid is not particularly limited, and may be a shape such as, for example, a roof shape (gable top shape), a rectangular parallelepiped shape (flat top shape, brick shape, straight shape, or the like), a triangular pyramid shape, a slant top shape, a regular tetrahedron shape, a cup shape, or a tray shape. Moreover, the paper container for liquid may include a straw insertion hole, a port cock, a lid material, and the like unless barrier properties are impaired.

A liquid that is accommodated by the paper container for liquid may be any food or non-food. The liquid that is accommodated by the paper container for liquid is not particularly limited, and examples thereof include alcoholic beverages such as Japanese sake, shochu, and wine; milk beverages such as milk; favorite beverages such as juice, coffee, tea, and black tea; food such as convenience foods, microwaveable foods, favorite food (yogurt, jelly, pudding, and the like), and deli food with liquids; pharmaceutical products; and chemical products such as car waxes, shampoos, rinses, detergents, bath salts, hair dyes, and dental powders.

### EXAMPLES

The features of the present disclosure are further specifically with reference to Examples and Comparative Examples. Materials, used amounts, proportions, the details of treatment, treatment procedures, and the like described in the following Examples can be changed as appropriate without departing from the gist of the present disclosure. Accordingly, the scope of the present disclosure should not be construed in a limited way by specific examples described below. Moreover, operations in Examples and Comparative Examples were performed under conditions of room temperature (20 to 25°C) and normal humidity (40 to 50% RH) unless otherwise specified.

### <Example 1>

### (Production of Base Paper for Vapor deposition paper)

A coating liquid for a clay coat layer was prepared by mixing 60 parts by mass (solid content) of kaolin (Contour Xtreme, manufactured by Imerys, aspect ratio of 33) and 40 parts by mass (solid content) of styrene-acrylic resin binder (Acronal S504, manufactured by BASF AG, glass transition temperature of 5°C). The coating liquid for a clay coat layer was applied to a high-smooth surface (Oken smoothness of 500 seconds) of a paper substrate (basis weight of 50 g/m², a paper thickness of 62 µm, machine-glazed bleached kraft paper, manufactured by Oji F-Tex Co., Ltd.) by Meyer bar coating process, and dried at 120°C for 1 minute to form a clay coat layer (12 g/m² in terms of solid content). Then, an aqueous dispersion liquid of a polyurethane resin binder (TAKELAC WPB-341, manufactured by Mitsui Chemicals, Inc.: glass transition temperature of 130°C) of which the oxygen permeability (23°C, 50% RH) in the case of forming a sheet having thickness of 25 µm was 2.0 mL/(m²·day·atm) was applied to the clay coat layer by Meyer bar coating process, and dried at 120°C for 1 minute to form a resin layer (1 g/m²) and to obtain base paper for vapor deposition paper having basis weight of 63 g/m² and thickness of 67 µm.

### (Production of Vapor deposition paper)

An aluminum vapor deposition layer (thickness of 50 nm) was formed on the resin layer of the above-described base paper for vapor deposition paper using a batch-type vacuum deposition apparatus. Then, an aqueous dispersion liquid of a polyurethane resin binder (TAKELAC WPB-341, manufactured by Mitsui Chemicals, Inc.) of which the oxygen permeability (23°C, 50% RH) in the case of forming a sheet having thickness of 25 µm was 2.0 mL/ (m²·day·atm) was applied to the aluminum vapor deposition layer by Meyer bar coating, and dried at 120°C for 1 minute to form an overcoat layer (0.5 g/m², thickness of 0.5 µm). Further, an aqueous dispersion liquid of an ethylene-methacrylic acid copolymer ammonium salt (active component content of 35% by mass, CHEMIPEARL S-300, manufactured by Mitsui Chemicals, Inc.) was diluted with water so that the active component content thereof was 20% by mass to give a liquid, then, the liquid was applied to the over coat layer by Meyer bar coating process and dried at 120°C for 1 minute to form a heat seal layer (3 g/m²) and to obtain vapor deposition paper having basis weight of 66.5 g/m² and thickness of 70 µm. When the polyurethane resin used in the resin layer and the overcoat layer was subjected to ¹H-NMR measurement, the content of a structural unit derived from m-xylylene diisocyanate with respect to the total amount of structural units derived from polyisocyanate was 50% by mol or more.

### <Example 2>

Base paper for vapor deposition paper having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that kaolin in a coating liquid for a clay coat layer was set at 70 parts by mass (solid content), and a styrene-acrylic resin binder was set at 30 parts by mass (solid content) in production of the base paper for vapor deposition paper.

### <Example 3>

Base paper for vapor deposition paper, having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that kaolin in a coating liquid for a clay coat layer was set at 50 parts by mass (solid content), and a styrene-acrylic resin binder was set at 50 parts by mass (solid content) in production of the base paper for vapor deposition paper.

### <Example 4>

Base paper for vapor deposition paper, having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that kaolin in a coating liquid for a clay coat layer was set at 30 parts by mass (solid content), and a styrene-acryl copolymer binder was set at 70 parts by mass (solid content) in production of the base paper for vapor deposition paper.

### <Example 5>

Base paper for vapor deposition paper, having basis weight of 59 g/m² and thickness of 65 µm, was produced in a manner similar to that in Example 1, and vapor deposition paper having basis weight of 62.5 g/m² and thickness of 68 µm was obtained in a manner similar to that in Example 1, except that the coating amount of a clay coat layer was set at 8 g/m² (in terms of solid content) in production of the base paper for vapor deposition paper.

### <Example 6>

Base paper for vapor deposition paper, having basis weight of 67 g/m² and thickness of 69 µm, was produced in a manner similar to that in Example 1, and vapor deposition paper having basis weight of 70.5 g/m² and thickness of 72 µm was obtained in a manner similar to that in Example 1, except that the coating amount of a clay coat layer was set at 16 g/m² (in terms of solid content) in production of the base paper for vapor deposition paper.

### <Example 7>

Base paper for vapor deposition paper, having basis weight of 71 g/m² and thickness of 71 µm, was produced in a manner similar to that in Example 1, and vapor deposition paper having basis weight of 74.5 g/m² and thickness of 74 µm was obtained in a manner similar to that in Example 1, except that the coating amount of a clay coat layer was set at 20 g/m² (in terms of solid content) in production of the base paper for vapor deposition paper.

### <Example 8>

Base paper for vapor deposition paper, having basis weight of 59 g/m² and thickness of 65 µm, was produced in a manner similar to that in Example 2, and vapor deposition paper having basis weight of 62.5 g/m² and thickness of 68 µm was obtained in a manner similar to that in Example 1 except that the coating amount of a clay coat layer was set at 8 g/m² (in terms of solid content) in production of the base paper for vapor deposition paper.

### <Example 9>

In production of vapor deposition paper, the vapor deposition paper having basis weight of 63.5 g/m² and thickness of 67 µm was obtained in a manner similar to that in Example 1 except that a heat seal layer was not formed.

### <Example 10>

A linear low-density polyethylene (LLDPE) film (T.U.X. TC-S30, manufactured by Mitsui Chemicals Tohcello Co., Ltd., thickness of 30 µm and basis weight of 28 g/m²) was coated with an adhesive agent with non-gas barrier properties (DICDRY LX-500/KW-75, manufactured by DIC Graphics Corporation) to form an adhesive layer so that the dry weight of the adhesive agent was 4 g/m², the vapor deposition paper obtained in Example 9 was then dry-laminated on the surface of the adhesive agent layer so that the overcoat layer comes into contact with the surface. Vapor deposition paper having basis weight of 95.4 g/m² and thickness of 96 µm was obtained.

### <Example 11>

The overcoat layer of the vapor deposition paper obtained in Example 9 was coated with low-density polyethylene by a melt extrusion lamination method so that the low-density polyethylene had thickness of 20 µm (basis weight of 18 g/m²). Vapor deposition paper having basis weight of 81.9 g/m² and thickness of 87 µm was obtained.

### <Example 12>

Vapor deposition paper having basis weight of 66.5 g/m² and thickness of 70 µm was obtained in a manner similar to that in Example 1 except that the coating liquid for a heat seal layer was changed to an aqueous dispersion liquid of a styrene-acrylic acid copolymer (active component content of 48% by mass, XP -8829, manufactured by SEIKO PMC CORPORATION) in production of the vapor deposition paper.

### <Example 13>

Vapor deposition paper having basis weight of 66.5 g/m² and thickness of 70 µm was obtained in a manner similar to that in Example 1 except that the coating liquid for an overcoat layer was changed to an ethyl acetate solution of a polyester resin (active component content of 30% by mass, Elitel UE-9800-30EA, manufactured by in UNITIKA LTD.) in production of the vapor deposition paper.

### <Example 14>

Vapor deposition paper having basis weight of 66.5 g/m² and thickness of 70 µm was obtained in a manner similar to that in Example 1 except that the coating liquid for an overcoat layer was changed to a water/alcohol solution of an ethylene-vinyl alcohol copolymer (active component content of 15% by mass, Soarnol 16DX, manufactured by Mitsubishi Chemical Corporation) in production of the vapor deposition paper.

### <Example 15>

Vapor deposition paper having basis weight of 66 g/m² and thickness of 70 µm was obtained in a manner similar to that in Example 1 except that an overcoat layer was not formed in production of the vapor deposition paper.

### <Example 16>

Vapor deposition paper having basis weight of 69 g/m² and thickness of 73 µm was obtained in a manner similar to that in Example 15 except that the coating amount of a heat seal layer was set at 6 g/m² in production of the vapor deposition paper.

### <Example 17>

Base paper for vapor deposition paper, having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that the styrene-acrylic resin binder in the coating liquid for a clay coat layer was changed to an ethylene-acrylic acid copolymer binder (active component content of 29.2% by mass, ZAIKTHENE AC, manufactured by Sumitomo Seika Chemicals Company, Limited., glass transition temperature of 51°C) in production of the base paper for vapor deposition paper.

### <Example 18>

Base paper for vapor deposition paper, having basis weight of 63 g/m² and thickness 67 µm, was produced in a manner similar to that in Example 1, and vapor deposition paper having basis weight of 66.5 g/m² and thickness of 70 µm was obtained in a manner similar to that in Example 1, except that the styrene-acrylic resin binder in the coating liquid for a clay coat layer was changed to styrene-butadiene latex (active component content of 50% by mass, Styronal ES7900, manufactured by BASF AG, glass transition temperature of -6°C) in production of the base paper for vapor deposition paper.

### <Example 19>

Base paper for vapor deposition paper, having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that the styrene-acrylic resin binder in the coating liquid for a clay coat layer was changed to an aqueous dispersion liquid of polylactic acid (active component content of 52% by mass, RESEM W-990, manufactured by CHUKYO YUSHI CO., LTD.), and the coating liquid for a resin layer was changed to an aqueous dispersion liquid of polylactic acid (active component content of 52% by mass, RESEM W-990, manufactured by CHUKYO YUSHI CO., LTD.) in production of the base paper for vapor deposition paper, and that the coating liquid for a heat seal layer was changed to an aqueous dispersion liquid of polylactic acid (active component content of 52% by mass, RESEM W-990, manufactured by CHUKYO YUSHI CO., LTD.) in production of the vapor deposition paper.

### <Example 20>

Base paper for vapor deposition paper having basis weight of 63 g/m² and thickness of 67 µm was produced in a manner similar to that in Example 1, and vapor deposition paper having basis weight of 66.5 g/m² and thickness 70 µm was obtained in a manner similar to that in Example 1, except that kaolin in the coating liquid for a clay coat layer was changed to calcium carbonate (Brilliant-15, manufactured by Shiraishi Kogyo Kaisha, Ltd., aspect ratio of 3) in production of the base paper for vapor deposition paper.

### <Example 21>

Base paper for vapor deposition paper, having basis weight of 83 g/m² and thickness of 93 µm, was produced in a manner similar to that in Example 1, and vapor deposition paper having basis weight of 86.5 g/m² and thickness of 96 µm was obtained in a manner similar to that in Example 1, except that the paper substrate was changed to machine-glazed bleached kraft paper for flexographic printing (basis weight of 70 g/m², paper thickness of 88 µm, Oken smoothness of coating surface of 160 seconds, OK Blizzard (for flexography), manufactured by Ojimateria Co., Ltd.) in production of the base paper for vapor deposition paper.

### <Example 22>

Base paper for vapor deposition paper, having basis weight of 136 g/m² and thickness of 175 µm, was produced in a manner similar to that in Example 1, and vapor deposition paper having basis weight of 139.5 g/m² and thickness of 178 µm was obtained in a manner similar to that in Example 1, except that the paper substrate was changed to unbleached flexible packaging base paper (basis weight of 120 g/m², paper thickness of 170 µm, Oken smoothness of coating surface of 11 seconds, manufactured by Ojimateria Co., Ltd.), and the coating amount of a clay coat layer was set at 15 g/m² in production of the base paper for vapor deposition paper.

### <Example 23>

Vapor deposition paper having basis weight of 66 g/m² and thickness 70 µm was obtained in a manner similar to that in Example 15 except that an aluminum vapor deposition layer (50 nm) was changed to a silicon oxide (silica) vapor deposition layer (20 nm).

### <Example 24>

Vapor deposition paper having basis weight of 66 g/m² and thickness 70 µm was obtained in a manner similar to that in Example 15 except that the aluminum vapor deposition layer (50 nm) was changed to an aluminum oxide (alumina) vapor deposition layer (20 nm).

### <Example 25>

Vapor deposition paper having basis weight of 66 g/m² and thickness of 70 µm was obtained in a manner similar to that in Example 15 except that the aluminum vapor deposition layer (50 nm) was changed to a diamond-like carbon vapor deposition layer (20 nm).

### <Example 26>

Vapor deposition paper having basis weight of 66.5 g/m² and thickness of 70 µm was obtained in a manner similar to that in Example 1 except that the aluminum vapor deposition layer (50 nm) was changed to a silicon oxide (silica) vapor deposition layer (20 nm).

### <Example 27>

Vapor deposition paper having basis weight of 66.5 g/m² and thickness of 70 µm was obtained in a manner similar to that in Example 1 except that the aluminum vapor deposition layer (50 nm) was changed to an aluminum oxide (alumina) vapor deposition layer (20 nm).

### <Example 28>

Vapor deposition paper having basis weight of 66.5 g/m² and thickness of 70 µm was obtained in a manner similar to that in Example 1 except that the aluminum vapor deposition layer (50 nm) was changed to a diamond-like carbon vapor deposition layer (20 nm).

### <Example 29>

Base paper for vapor deposition paper, having basis weight of 351 g/m² and thickness 463 µm, was produced in a manner similar to that in Example 1, and vapor deposition paper having basis weight of 351.5 g/m² and thickness of 464 µm was obtained in a manner similar to that in Example 1, except that the paper substrate was changed to paperboard (basis weight of 330 g/m², paper thickness of 456 µm, Oken smoothness of coating surface of 11 seconds, OK Pienas, manufactured by Ojimateria Co., Ltd.) and the coating amount of a clay coat layer was set at 20 g/m² in production of the base paper for vapor deposition paper, and that a heat seal layer was not formed in production of the vapor deposition paper.

### <Comparative Example 1>

Base paper for vapor deposition paper, having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that kaolin in the coating liquid for a clay coat layer was set at 80 parts by mass (solid content), and the styrene-acrylic resin binder was set at 20 parts by mass (solid content) in production of the base paper for vapor deposition paper.

### <Comparative Example 2>

Base paper for vapor deposition paper, having basis weight of 63 g/m² and thickness of 67 µm, was produced in a manner similar to that in Example 1, and vapor deposition paper having basis weight of 66.5 g/m² and thickness of 70 µm was obtained in a manner similar to that in Example 1, except that kaolin in the coating liquid for a clay coat layer was set at 20 parts by mass (solid content), and the styrene-acrylic resin binder was set at 80 parts by mass (solid content) in production of the base paper for vapor deposition paper.

### <Comparative Example 3>

Base paper for vapor deposition paper, having basis weight of 57 g/m² and thickness of 65 µm, was produced in a manner similar to that in Example 1, and vapor deposition paper having basis weight of 60.5 g/m² and thickness of 68 µm was obtained in manner similar to that in Example 1, except that the coating amount of a clay coat layer was set at 6 g/m² (in terms of solid content) in production of the base paper for vapor deposition paper.

### <Comparative Example 4>

Base paper for vapor deposition paper, having basis weight of 76 g/m² and thickness of 71 µm, was produced in a manner similar to that in Example 1, and vapor deposition paper having basis weight of 79.5 g/m² and thickness of 75 µm was obtained in a manner similar to that in Example 1 except that coating amount of a clay coat layer was set at 25 g/m² (in terms of solid content) in production of the base paper for vapor deposition paper.

### <Comparative Example 5>

Base paper for vapor deposition paper, having basis weight of 351 g/m² and thickness of 463 µm, was produced in a manner similar to that in Comparative Example 1, and vapor deposition paper having basis weight of 351.5 g/m² and thickness of 464 µm was obtained in a manner similar to that in Comparative Example 1 except that the paper substrate was changed to paperboard (basis weight of 330 g/m², paper thickness of 456 µm, Oken smoothness of coated surface of 11 seconds, OK Pienas, manufactured by Ojimateria Co., Ltd.) and the coating amount of a clay coat layer was set at 20 g/m² in production of the base paper for vapor deposition paper, and that a heat seal layer was not formed in production of the vapor deposition paper.

### <Evaluation of Vapor deposition paper>

The following evaluation of the vapor deposition paper obtained in each of Examples and Comparative Examples was performed. The results are set forth in Tables 1 to 5.

### [Evaluation of Stain in Bending]

The vapor deposition paper obtained in each of Examples and Comparative Examples was bent once (at a folding angle of 180°) using a rubber covered roller having a mass of 700 g and a width of 30 cm so that the coating layer thereof was an inner side. Then, a heat seal checker (registered trademark: AGELESS seal check, manufactured by MITSUBISHI GAS CHEMICAL COMPANY, INC.) was sprayed from an area closer to the coating layer, and wiped off 120 seconds later. Whether a fold on the paper side of the back surface thereof was stained with the heat seal checker was confirmed by visual observation, and evaluation was performed based on the following criteria.
S: The number of spot-like stains having a diameter of 1 cm or less was zero.
A: The number of spot-like stains having a diameter of 1 cm or less was one to three.
B: The number of spot-like stains having a diameter of 1 cm or less was four or more, or a stain having a diameter of 1 cm or more was observed.

### [Oxygen permeability]

### (Oxygen Permeability before Bending)

The oxygen permeability of the vapor deposition paper was measured using an oxygen permeability measuring device (OX-TRAN2/22, manufactured by MOCON) under conditions of a temperature of 23°C and a relative humidity of 50%. Specifically, the coating layer surface of the vapor deposition paper obtained in each of Examples and Comparative Examples was coated with 5 g/m² of an isocyanate-based adhesive agent (10 parts by mass of DICDRY LX-500 manufactured by DIC Corporation, mixed with 1 part by mass of DICDRY KW-75), and a CPP film having thickness of 20 µm (GP -32, manufactured by Hokuetu Kasei) was then bonded thereto to form a laminated sheet. The oxygen permeability of the laminated sheet at a temperature of 23°C and a relative humidity of 50% was measured according to JIS K7126-2: 2006. The lower value of the oxygen permeability means that the higher oxygen barrier property of the vapor deposition paper.

### (Oxygen Permeability after Bending)

The oxygen permeability after bending was also measured for evaluation of working resistance. In a bending method, vapor deposition paper was bent once using a rubber roller having a mass of 700 g and a width of 30 cm (at a folding angle of 180°), then opened, bent again along a line perpendicular to a folding line (at a folding angle of 180°), and then opened, the laminated sheet was formed, a point of intersection of the folding lines was then positioned at the center of the measurement unit of the oxygen permeability measuring devices, and the oxygen permeability was measured.

### (Oxygen Permeability of Empty Bag)

An empty bag having an inside dimension of 14 cm × 22 cm was produced from the vapor deposition paper obtained in each of Examples and Comparative Examples by using a horizontal pillow packaging machine (FW3410/Bα8, manufactured by FUJI MACHINERY CO., LTD.). The oxygen permeability of the package of the empty bag was measured using the oxygen permeability measuring device (OX-TRAN2/22, manufactured by MOCON) and an attached paper carton adapter under conditions of a temperature 23°C and a relative humidity of 50%.

### [Water Vapor Permeability]

### (Water Vapor Permeability before Bending)

The water vapor permeability of the vapor deposition paper obtained in each of Examples and Comparative Examples was measured according to JIS Z 0208: 1976 (Dish Method) Method B (40°C ± 0.5°C, relative humidity of 90% ± 2%) in a state in which a coating layer was an inner side. The lower value of the water vapor permeability means the higher water vapor barrier property of the vapor deposition paper.

### (Water Vapor Permeability after Bending)

A water vapor permeability after bending was also measured for evaluation of working resistance. In a bending method, vapor deposition paper was bent once using a rubber roller having a mass of 700 g and a width of 30 cm (at a folding angle of 180°), then opened, bent again along a line perpendicular to a folding line (at a folding angle of 180°), and then opened, the laminated sheet was formed, a point of intersection of the folding lines was then positioned at the center of the measurement unit of a water vapor permeability measuring device, and the water vapor permeability was measured.

### (Oxygen Permeability of Paper Container for Liquid)

Molten low-density polyethylene (NOVATEC LD LC600A, manufactured by Japan Polyethylene Corporation) was extruded on both surfaces of the vapor deposition paper obtained in each of Example 29 and Comparative Example 5 to obtain a laminate with basis weight of 388.3 g/m² and thickness of 504 µm, including an LDPE layer having thickness of 20 µm (basis weight of 18.4 g/m²) on each of the front and back surfaces of the vapor deposition paper. Ruled lines were disposed on the necessary parts of the laminate, and the laminate was stamped to have a predetermined shape to obtain a blank. Then, the body parts thereof were bonded to each other with a frame seal to obtain a cylindrical sleeve. Subsequently, the cylindrical sleeve was fed to a filling machine, a bottom part was formed, and a top part was then sealed to produce a gable-top-type paper container for liquid, having a capacity of 1000 mL. For the paper container for liquid, the oxygen permeability of the paper container for liquid was measured using the oxygen permeability measuring device (OX-TRAN2/22, manufactured by MOCON) and an attached paper carton adapter under conditions of a temperature 23°C and a relative humidity of 50%.

### [Table 1]

**Table 1**

| | | | | Example 1 | Example 2 | Example 3 | Example 4 |
|---|---|---|---|---|---|---|---|
| vapor deposition paper | base paper for vapor deposition paper | paper substrate | paper | machine-glazed bleached kraft paper | | | |
| | | | basis weight (g/m²) | 50 | | | |
| | | | thickness (µm) | 62 | | | |
| | | day coat layer | inorganic pigment | kaolin | | | |
| | | | binder | styrene-acrylic resin | | | |
| | | | inorganic pigment/binder (mass ratio) | 60/40 | 70/30 | 50/50 | 30/70 |
| | | | coating amount^{*1} (g/m²) | 12 | 12 | 12 | 12 |
| | | resin layer | resin type | polyurethane resin | | | |
| | vapor deposition layer | | vapor deposition material | aluminum | | | |
| | over coat layer | | resin type | polyurethane resin | | | |
| | heat seal layer | | resin type | ethylene-methacrylic acid copolymer ammonium salt | | | |
| | | | basis weight^{*1} (g/m²) | 3 | 3 | 3 | 3 |
| property evaluation | base paper | basis weight (g/m²) | | 63 | 63 | 63 | 63 |
| | | thickness (µm) | | 67 | 67 | 67 | 67 |
| | vapor deposition paper | basis weight (g/m²) | | 66.5 | 66.5 | 66.5 | 66.5 |
| | | thickness (µm) | | 70 | 70 | 70 | 70 |
| | | stain resistance at bent portion | | S | S | S | A |
| | | oxygen permeability ml/(m²·day·atm) | before bending | 0.1 | 0.1 | 0.3 | 0.8 |
| | | | after bending | 0.2 | 0.3 | 0.4 | 1.7 |
| | | water vapor permeability g/(m²·day) | before bending | 0.3 | 0.3 | 0.5 | 0.9 |
| | | | after bending | 0.4 | 0.4 | 0.7 | 1.4 |
| | empty bag | oxygen permeability mU(pkg-day-0.2atm) | | 0.003 | 0.004 | 0.005 | 0.029 |

| | | | | | | | |
|---|---|---|---|---|---|---|---|
| *1: coating amount in terms of solid content, when the day coat layer was formed by coating process | | | | | | | |

**Table 1-continued**

| | | | | Example 5 | Example 6 | Example 7 | Example 8 |
|---|---|---|---|---|---|---|---|
| vapor deposition paper | base paper for vapor deposition paper | paper substrate | paper | machine-glazed bleached kraft paper | | | |
| | | | basis weight (g/m²) | 50 | | | |
| | | | thickness (µm) | 62 | | | |
| | | day coat layer | inorganic pigment | kaolin | | | |
| | | | binder | styrene-acrylic resin | | | |
| | | | inorganic pigment/binder (mass ratio) | 60/40 | 60/40 | 60/40 | 70/30 |
| | | | coating amount^{*1} (g/m²) | 8 | 16 | 20 | 8 |
| | | resin layer | resin type | polyurethane resin | | | |
| | vapor deposition layer | | vapor deposition material | aluminum | | | |
| | over coat layer | | resin type | polyurethane resin | | | |
| | heat seal layer | | resin type | ethylene-methacrylic acid copolymer ammonium salt | | | |
| | | | basis weight^{*1} (g/m²) | 3 | 3 | 3 | 3 |
| property evaluation | base paper | basis weight (g/m²) | | 59 | 67 | 71 | 59 |
| | | thickness (µm) | | 65 | 69 | 71 | 65 |
| | vapor deposition paper | basis weight (g/m²) | | 62.5 | 70.5 | 74.5 | 62.5 |
| | | thickness (µm) | | 68 | 72 | 74 | 68 |
| | | stain resistance at bent portion | | A | S | A | A |
| | | oxygen permeability ml/(m²·day·atm) | before bending | 0.4 | 0.2 | 0.1 | 0.4 |
| | | | after bending | 1.5 | 0.3 | 0.6 | 1.7 |
| | | water vapor permeability g(m²·day) | before bending | 0.7 | 0.5 | 0.4 | 0.7 |
| | | | after bending | 0.9 | 0.6 | 0.6 | 1.1 |
| | empty bag | oxygen permeability mL/(pkg·day·0.2atm) | | 0.021 | 0.006 | 0.008 | 0.025 |

| | | | | | | | |
|---|---|---|---|---|---|---|---|
| *1: coating amount in terms of solid content, when the day coat layer was formed by coating process | | | | | | | |

### [Table 2]

**Table 2**

| | | | | Example 9 | Example 10 | Example 11 | Example 12 |
|---|---|---|---|---|---|---|---|
| vapor deposition paper | base paper for vapor deposition paper | paper substrate | paper | machine-glazed bleached kraft paper | | | |
| | | | basis weight (g/m²) | 50 | | | |
| | | | thickness (µm) | 62 | | | |
| | | day coat layer | inorganic pigment | kaolin | | | |
| | | | Binder | styrene-acrilyc resin | | | |
| | | | inorganic pigment/binder (mass ratio) | 60/40 | 60/40 | 60/40 | 60/40 |
| | | | coating amount^{*1} (g/m²) | 12 | 12 | 12 | 12 |
| | | resin layer | resin type | polyurethane resin | | | |
| | vapor deposition layer | | vapor deposition material | aluminum | | | |
| | over coat layer | | resin type | polyurethane resin | | | |
| | heat seal layer | | resin type | -^{*3} | LLDPE | LDPE | -^{*3} |
| | | | basis weight^{*1} (g/m²) | -^{*3} | 28 | 18 | -^{*3} |
| property evaluation | base paper | basis weight (g/m²) | | 63 | 63 | 63 | 63 |
| | | thickness (µm) | | 67 | 67 | 67 | 67 |
| | vapor deposition paper | basis weight (g/m²) | | 63.5 | 95.4 | 81.9 | 66.5 |
| | | thickness (µm) | | 67 | 96 | 87 | 70 |
| | | stain resistance at bent portion | | S | S | S | S |
| | | oxygen permeability mL/(m²·day·atm) | before bending | 0.2 | 0.2 | 0.2 | 0.1 |
| | | | after bending | 0.6 | 0.4 | 0.5 | 0.3 |
| | | water vapor permeability g/(m²·day) | before bending | 0.6 | 0.6 | 0.6 | 0.4 |
| | | | after bending | 0.9 | 0.7 | 0.8 | 0.6 |
| | empty bag | oxygen permeability mL/(pkg·day·0.2atm) | | - | 0.003 | 0.003 | 0.003 |

| | | | | | | | |
|---|---|---|---|---|---|---|---|
| *1: coating amount in terms of solid content, when the clay coat layer was formed by coating process *2: an over coat layer was not formed *3: a heat seal layer was not formed | | | | | | | |

**Table 2-continued**

| | | | | Example 13 | Example 14 | Example 15 | Example 16 |
|---|---|---|---|---|---|---|---|
| vapor deposition paper | base paper for vapor deposition paper | paper substrate | paper | machine-glazed bleached kraft paper | | | |
| | | | basis weight (g/m²) | 50 | | | |
| | | | thickness (µm) | 62 | | | |
| | | day coat layer | inorganic pigment | kaolin | | | |
| | | | Binder | styrene-acrylic resin | | | |
| | | | inorganic pigment/binder (mass ratio) | 60/40 | 60/40 | 60/40 | 60/40 |
| | | | coating amount^{*1} (g/m²) | 12 | 12 | 12 | 12 |
| | | resin layer | resin type | polyurethane resin | | | |
| | vapor deposition layer | | vapor deposition material | aluminum | | | |
| | over coat layer | | resin type | polyester resin | ethylene-vinyl alcohol copolymer | -^{*2} | -^{*2} |
| | heat seal layer | | resin type | ethylene-methacrylic acid copolymer ammonium salt | | | |
| | | | basis weight^{*1} (g/m²) | 3 | 3 | 3 | 6 |
| evaluation | base paper | basis weight (g/m²) | | 63 | 63 | 63 | 63 |
| | | thickness (µm) | | 67 | 67 | 67 | 67 |
| | vapor deposition paper | basis weight (g/m²) | | 66.5 | 66.5 | 66 | 69 |
| | | thickness (µm) | | 70 | 70 | 70 | 73 |
| | | stain resistance at bent portion | | S | S | S | S |
| | | oxygen permeability mL/(m²·day·atm) | before bending | 0.3 | 0.2 | 0.4 | 0.3 |
| | | | after bending | 0.5 | 0.4 | 0.8 | 0.5 |
| | | water vapor permeability g/(m²·day) | before bending | 0.5 | 0.4 | 0.5 | 0.4 |
| | | | after bending | 0.6 | 0.6 | 0.8 | 0.5 |
| | empty bag | oxygen permeability mL/(pkg·day·0.2atm) | | 0.007 | 0.006 | 0.010 | 0.008 |

| | | | | | | | |
|---|---|---|---|---|---|---|---|
| *1: coating amount in terms of solid content, when the day coat layer was formed by coating process *2: an over coat layer was not formed *3: a heat seal layer was not formed | | | | | | | |

### [Table 3]

**Table 3**

| | | | | Example 17 | Example 18 | Example 19 | Example 20 |
|---|---|---|---|---|---|---|---|
| vapor deposition paper | base paper for vapor deposition paper | paper substrate | paper | machine-glazed bleached kraft paper | | | |
| | | | basis weight (g/m²) | 50 | | | |
| | | | thickness (µm) | 62 | | | |
| | | day coat layer | inorganic pigment | kaolin | | | calcium carbonate |
| | | | binder | ethylene-acrylic acid copolymer | styrene-butadiene latex | polylactic aid | styrene-acrylic resin |
| | | | (mass ratio) pigment/binder | 60/40 | 60/40 | 60/40 | 60/40 |
| | | | coating arnount^{*1} (g/m²) | 12 | 12 | 12 | 12 |
| | | resin layer | resin type | polyurethane resin | | polylactic acid | polyurethane resin |
| | vapor deposition layer | | vapor deposition material | aluminum | | | |
| | over coat layer | | resin type | polyurethane resin | | | |
| | heat seal layer | | resin type | ethylene-methacrylic acid copolymer ammonium salt | | polylactic acid | ethylene-methacrylic acid copolymer ammonium salt |
| | | | basis weight^{*1} (g/m²) | 3 | 3 | 3 | 3 |
| property evaluation | base paper | basis weight (g/m²) | | 63 | 63 | 63 | 63 |
| | | thickness (µm) | | 67 | 67 | 67 | 67 |
| | vapor deposition paper | basis weight (g/m²) | | 66.5 | 66.5 | 66.5 | 66.5 |
| | | thickness (µm) | | 70 | 70 | 70 | 70 |
| | | stain resistance at bent portion | | S | S | S | S |
| | | oxygen permmeability ml/(m²▪day▪atm) | before bending | 0.3 | 0.4 | 0.4 | 0.3 |
| | | | after bending | 0.5 | 0.6 | 0.7 | 0.7 |
| | | water vapor permeability g/(m²▪day) | before bending | 0.5 | 0.5 | 0.6 | 0.6 |
| | | | after bending | 0.7 | 0.8 | 0.9 | 1.0 |
| | empty bag | oxygen permeability mL/(pkg▪day▪0.2atm) | | 0.007 | 0.008 | 0.010 | 0.015 |

| | | | | | | | |
|---|---|---|---|---|---|---|---|
| *1: coating amount in terms of solid content, when the day coat layer was formed by coating process | | | | | | | |

**Table 3-continued**

| | | | | Example 21 | Example 22 |
|---|---|---|---|---|---|
| vapor deposition paper | base paper for vapor deposition paper | paper substrate | paper | machine-glazed bleached kraft paper | unbleached flexible packaging base paper |
| | | | basis weight (g/m²) | 70 | 120 |
| | | | thickness (µm) | 88 | 170 |
| | | day coat layer | inorganic pigment | kaolin | |
| | | | binder | styrene-acrylic resin | |
| | | | inorganic pigment/binder (mass ratio) | 60/40 | 60/40 |
| | | | coating amount^{*1} (g/m²) | 12 | 15 |
| | | resin layer | resin type | polyurethane resin | |
| | vapor deposition layer | | vapor deposition material | aluminum | |
| | over coat layer | | resin type | polyurethane resin | |
| | heat seal layer | | resin type | ethylene-methacrylic acid copolymer ammonium salt | |
| | | | basis weight^{*1} (g/m²) | 3 | 3 |
| property evaluation | base paper | basis weight (g/m²) | | 83 | 136 |
| | | thickness (µm) | | 93 | 175 |
| | vapor deposition paper | basis weight (g/m²) | | 86.5 | 139.5 |
| | | thickness (µm) | | 96 | 178 |
| | | stain resistance at bent portion | | S | S |
| | | oxygen permeability mL/(m²·day·atm) | before bending | 0.4 | 0.8 |
| | | | after bending | 0.5 | 1.0 |
| | | water vapor permeability g/(m²·day) | before bending | 0.8 | 1.2 |
| | | | after bending | 0.9 | 1.4 |
| | empty bag | oxygen permeability mL/(pkg·day·0.2atm) | | 0.010 | 0.015 |

| | | | | | |
|---|---|---|---|---|---|
| *1: coating amount in terms of solid content, when the day coat layer was formed by coating process | | | | | |

### [Table 4]

**Table 4**

| | | | | Example 23 | Example 24 | Example 25 |
|---|---|---|---|---|---|---|
| vapor deposition paper | base paper for vapor deposition paper | paper substrate | paper | machine-glazed bleached kraft paper | | |
| | | | basis weight (g/m²) | 50 | | |
| | | | thickness (µm) | 62 | | |
| | | day coat layer | inorganic pigment | kaolin | | |
| | | | binder | styrene-acrylic resin | | |
| | | | inorganic pigment/binder (mass ratio) | 60/40 | 60/40 | 60/40 |
| | | | coating amount^{*1} (g/m²) | 12 | 12 | 12 |
| | | resin layer | resin type | polyurethane resin | | |
| | vapor deposition layer | | vapor deposition material | silica | alumina | diamond-like carbon |
| | over coat layer | | resin type | -^{*2} | -^{*2} | -^{2*} |
| | heat seal layer | | resin type | ethylene-methacrylic acid copolymer ammonium salt | | |
| | | | basis weight^{*1} (g/m²) | 3 | 3 | 3 |
| property evaluation | base paper | basis weight (g/m²) | | 63 | 63 | 63 |
| | | thickness (µm) | | 67 | 67 | 67 |
| | vapor deposition paper | basis weight (g/m²) | | 66 | 66 | 66 |
| | | thickness (µm) | | 70 | 70 | 70 |
| | | stain resistance at bent portion | | S | S | S |
| | | oxygen permeability mL/(m²·day·atm) | before bending | 0.3 | 0.3 | 0.2 |
| | | | after bending | 0.9 | 0.8 | 0.4 |
| | | water vapor permeability g/(m²·day) | before bending | 0.5 | 0.3 | 0.3 |
| | | | after bending | 0.9 | 0.8 | 0.6 |
| | empty bag | oxygen permeability mL/(pkg·day·0.2atm) | | 0.010 | 0.010 | 0.008 |

| | | | | | | |
|---|---|---|---|---|---|---|
| *1: coating amount in tenns of solid content, when the day coat layer was formed by coating process *2: an over coat layer was not formed | | | | | | |

**Table 4-continued**

| | | | | Example 26 | Example 27 | Example 28 |
|---|---|---|---|---|---|---|
| vapor deposition paper | base paper for vapor deposition paper | paper substrate | paper | machine-glazed bleached kraft paper | | |
| | | | basis weight (g/m²) | 50 | | |
| | | | thickness (µm) | 62 | | |
| | | day coat layer | inorganic pigment | kaolin | | |
| | | | binder | styrene-acrylic resin | | |
| | | | inorganic pigment/binder (mass ratio) | 60/40 | 60/40 | 60/40 |
| | | | coating arnount^{*1} (g/m²) | 12 | 12 | 12 |
| | | resin layer | resin type | polyurethane resin | | |
| | vapor deposition layer | | vapor deposition material | silica | alumina | diamond-like carbon |
| | over coat layer | | resin type | polyurethane resin | | |
| | heat seal layer | | resin type | ethylene-methacrylic acid copolymer ammonium salt | | |
| | | | basis weight^{*1} (g/m²) | 3 | 3 | 3 |
| property evaluation | base paper | basis weight (g/m²) | | 63 | 63 | 63 |
| | | thickness (µm) | | 67 | 67 | 67 |
| | vapor deposition paper | basis weight (g/m²) | | 66.5 | 66.5 | 66.5 |
| | | thickness (µm) | | 70 | 70 | 70 |
| | | stain resistance at bent portion | | S | S | S |
| | | oxygen permeability mL/(m²·day·atm) | before bending | 0.2 | 0.1 | 0.1 |
| | | | after bending | 0.5 | 0.3 | 0.3 |
| | | water vapor permeability g/(m²·day) | before bending | 0.5 | 0.3 | 0.2 |
| | | | after bending | 0.7 | 0.4 | 0.3 |
| | empty bag | oxygen permeability mL/(pkg·day·0.2atm) | | 0.006 | 0.004 | 0.004 |

| | | | | | | |
|---|---|---|---|---|---|---|
| *1: coating amount in terms of solid content, when the day coat layer was formed by coating process *2: an over coat layer was not formed | | | | | | |

### [Table 5]

**Table 5**

| | | | | Comparative Example1 | Comparative Example2 | Comparative Example3 | Comparative Example4 |
|---|---|---|---|---|---|---|---|
| vapor deposition paper | base paper for vapor deposition paper | paper substrate | paper | machine-glazed bleached kraft paper | | | |
| | | | basis weight (g/m²) | 50 | | | |
| | | | thickness (µm) | 62 | | | |
| | | clay coat layer | inorganic pigment | kaolin | | | |
| | | | binder | styrene-acrylic resin | | | |
| | | | inorganic pigment/binder (mass ratio) | 80120 | 20/80 | 60/40 | 60/40 |
| | | | coating amount^{*1} (g/m²) | 12 | 12 | 6 | 25 |
| | | resin layer | resin type | polyurethane resin | | | |
| | vapor deposition layer | | vapor deposition material | aluminum | | | |
| | over coat layer | | resin type | polyurethane resin | | | |
| | heat seal layer | | resin type | ethylene-methacrylic acid copolymer ammonium salt | | | |
| | | | coating amount^{*1} (g/m²) | 3 | 3 | 3 | 3 |
| evaluation | base paper | basis weight(g/m²) | | 63 | 63 | 57 | 76 |
| | | thickness(µm) | | 67 | 67 | 65 | 71 |
| | vapor deposition paper | basis weight(g/m²) | | 66.5 | 66.5 | 60.5 | 79.5 |
| | | thickness(µm) | | 70 | 70 | 68 | 75 |
| | | stain resistance at bent portion | | B | A | B | B |
| | | oxygen permeability ml/(m²·day·atm) | before bending | 0.3 | 5.3 | 0.6 | 0.2 |
| | | | after bending | 12.7 | 14.9 | 27.5 | 10.1 |
| | | water vapor permeability g/(m²·day) | before bending | 0.4 | 6.1 | 0.8 | 0.3 |
| | | | after bending | 3.3 | 8.5 | 5.0 | 2.9 |
| | empty bag | oxygen permeability mL/(pkg·day·0.2atm) | | 0.189 | 0.231 | 0.416 | 0.142 |

| | | | | | | | |
|---|---|---|---|---|---|---|---|
| *1: coating amount in terms of solid content, when the day coat layer was formed by coating process | | | | | | | |

### [Table 6]

**Table 6**

| | | | | Example 29 | Comparative Example 5 |
|---|---|---|---|---|---|
| vapor deposition paper | base paper for vapor deposition paper | paper substrate | paper | paperboard | |
| | | | basis weight (g/m²) | 330 | |
| | | | thickness (µm) | 456 | |
| | | day coat layer | inorganic pigment | kaolin | |
| | | | binder | styrene-acrylic resin | |
| | | | inorganic pigment/binder (mass ratio) | 60140 | 80/20 |
| | | | coating amount^{*1} (g/m²) | 20 | 20 |
| | | resin layer | resin type | polyurethane resin | |
| | vapor deposition layer | | vapor deposition material | aluminum | |
| | over coat layer | | resin type | polyurethane resin | |
| | heat seal layer | | | -^{*2} | |
| property evaluation | base paper | basis weight (g/m²) | | 351 | 351 |
| | | thickness (µm) | | 463 | 463 |
| | vapor deposition paper | basis weight (g/m²) | | 351.5 | 351.5 |
| | | thickness (µm) | | 464 | 464 |
| | | stain resistance at bent portion | | S | B |
| | | oxygen permeability ml/(m²·day·atm) | before bending | 0.4 | 0.4 |
| | | | after bending | 0.5 | 10.9 |
| | | water vapor permeability g/(m²·day) | before bending | 0.7 | 0.8 |
| | | | after bending | 0.9 | 2.6 |
| | paper container for liquid | oxygen permeability mL/(pkg·day·0.2atm) | | 0.008 | 0.095 |

| | | | | | |
|---|---|---|---|---|---|
| *1: coating amount in terms of solid content, when the day coat layer was formed by coating process *2: a heat seal layer was not formed | | | | | |

Based on the results of Examples, it is found that base paper for vapor deposition paper including a clay coat layer and a resin layer on a paper substrate, in which the mass ratio (inorganic pigment/binder) of an inorganic pigment to a binder in the clay coat layer and the coating amount of the clay coat layer are in specific ranges, enables vapor deposition paper having high barrier properties (oxygen barrier property and water vapor barrier property) to be provided regardless of the kind of the paper substrate, the kind of the binder, the kind of a resin included in the resin layer, and the like. Moreover, it is found that the high barrier properties of the vapor deposition paper in each of Examples are maintained, even after bending work, regardless of the kind of a material forming a vapor deposition layer, the presence or absence and the material of an overcoat layer, and the presence or absence and the material of a heat seal layer, and, accordingly, the vapor deposition paper is also excellent in working resistance.

Further, an empty bag produced with the vapor deposition paper in each of Examples, and a paper container for liquid, produced from a laminate including a thermoplastic resin layer, the vapor deposition paper in each of Examples, and a sealant layer in this order were confirmed to exhibit high oxygen barrier properties.

Based on the results, it may be considered that the vapor deposition paper in each of Examples can be preferably used in a packaging application such as a packaging bag or a paper container for liquid.

In contrast, based on the results of Comparative Examples, it is found that barrier properties (oxygen barrier property and water vapor barrier property) are considerably degraded after bending work in cases in which the inorganic pigment/binder ratio of a clay coat layer is more than 75/25 (Comparative Example 1), and in which the coating amount of a clay coat layer does not satisfy a range of 8 to 20 g/m² (Comparative Examples 3 and 4). Moreover, it is found that both the barrier properties and working resistance of vapor deposition paper are insufficient because barrier properties (oxygen barrier property and water vapor barrier property) are poor in a stage before bending work, and the barrier properties are further degraded after the bending work in a case in which a ratio between an inorganic pigment and a binder in a clay coat layer is less than 25/75 (Comparative Example 2).

## Claims

1. Base paper for vapor deposition paper, the base paper comprising, on at least one surface of a paper substrate, a clay coat layer and a resin layer in order mentioned from the paper substrate, wherein
the clay coat layer comprises an inorganic pigment and a binder,
a mass ratio (inorganic pigment/binder) of the inorganic pigment to the binder in the clay coat layer is from 25/75 to 75/25, and
a coating amount (in terms of solid content) of the clay coat layer is 8 g/m² or more and 20 g/m² or less.

2. The base paper for vapor deposition paper according to claim 1, wherein the inorganic pigment comprises one or more selected from the group consisting of kaolin and calcium carbonate.

3. The base paper for vapor deposition paper according to claim 1 or 2, wherein the binder comprises one or more selected from the group consisting of a styrene-(meth)acrylic resin, an ethylene-(meth)acrylic acid copolymer, a styrene-butadiene resin, and polylactic acid.

4. The base paper for vapor deposition paper according to any one of claims 1 to 3, wherein the resin layer comprises one or more selected from the group consisting of a polyurethane resin and polylactic acid.

5. Vapor deposition paper comprising the base paper for vapor deposition paper according to any one of claims 1 to 4 and a vapor deposition layer, wherein
the vapor deposition layer is disposed on the resin layer of the base paper for vapor deposition paper.

6. The vapor deposition paper according to claim 5, wherein at least one of an overcoat layer and a heat seal layer is disposed on the vapor deposition layer.

7. A packaging bag using the vapor deposition paper according to claim 5 or 6.

8. A laminate comprising a thermoplastic resin layer, the vapor deposition paper according to claim 5 or 6, and a sealant layer in this order.

9. A paper container for liquid, comprising the laminate according to claim 8.
